# EUROPEAN PATENT APPLICATION

(11) **EP 4 261 883 A1**
(43) Date of publication of application: **18.10.2023**
(21) Application number: 21902090.6
(22) Date of filing: 27.08.2021
(51) Int. Cl.: H01L 23/538, H01L 21/48

(54) **SEMICONDUCTOR APPARATUS HAVING SIDE WALL INTERCONNECTION STRUCTURE AND MANUFACTURING METHOD FOR SEMICONDUCTOR APPARATUS, AND ELECTRONIC DEVICE**

(30) Priority: 11.12.2020 CN 202011463249
(71) Applicant: Institute Of Microelectronics, Chinese Academy Of Sciences, Beijing 100029 (CN)
(72) Inventor: ZHU, Huilong, Poughkeepsie New York 12603 (US)
(74) Representative: Zimmermann, Tankred Klaus
(86) International application number: PCT/CN2021/115008
(87) International publication number: WO 2022/121382

(57) **Abstract**

Disclosed are a semiconductor apparatus with a sidewall interconnection structure, a method of manufacturing the semiconductor apparatus, and an electronic device including the semiconductor apparatus. According to embodiments, the semiconductor apparatus may include: a plurality of device stacks, wherein each device stack includes a plurality of semiconductor devices that are stacked, and each semiconductor device includes a first source/drain layer, a channel layer, and a second source/drain layer that are stacked in a vertical direction, and a gate electrode surrounding the channel layer; and an interconnection structure disposed between the plurality of device stacks. The interconnection structure may include: an electrical isolation layer; and a conductive structure in the electrical isolation layer. At least one of the first source/drain layer, the second source/drain layer, and the gate electrode of each of at least one of the semiconductor devices is in contact with and thus electrically connected to the conductive structure at a corresponding height in the interconnection structure in a lateral direction.

## Description

### CROSS REFERENCE TO RELATED APPLICATION(S)

This application claims priority to Chinese Patent Application No. 202011463249.8 entitled "SEMICONDUCTOR APPARATUS WITH SIDEWALL INTERCONNECTION STRUCTURE, METHOD OF MANUFACTURING SEMICONDUCTOR APPARATUS WITH SIDEWALL INTERCONNECTION STRUCTURE, AND ELECTRONIC DEVICE", filed on December 11, 2020, the content of which is incorporated herein by reference in its entirety.

### TECHNICAL FIELD

The present disclosure relates to a field of semiconductors, and in particular, to a semiconductor apparatus with a sidewall interconnection structure, a method of manufacturing the semiconductor apparatus with the sidewall interconnection structure, and an electronic device including the semiconductor apparatus.

### BACKGROUND

With a continuous miniaturization of a semiconductor device, it is increasingly difficult to manufacture a high-density interconnection structure because of a difficulty in reducing a size in a lateral direction. In addition, in order to increase an integration level, multilayer devices may be stacked. It is desired to provide an interconnection for such stacked devices in a flexible manner.

### SUMMARY

In view of this, an objective of the present disclosure is, at least in part, to provide a semiconductor apparatus with a sidewall interconnection structure, a method of manufacturing the semiconductor apparatus, and an electronic device including the semiconductor apparatus.

According to an aspect of the present disclosure, a semiconductor apparatus is provided, including: a plurality of device stacks, wherein each device stack includes a plurality of semiconductor devices that are stacked, and each semiconductor device includes a first source/drain layer, a channel layer, and a second source/drain layer that are stacked in a vertical direction, and a gate electrode surrounding the channel layer; and an interconnection structure disposed between the plurality of device stacks. The interconnection structure includes: an electrical isolation layer; and a conductive structure in the electrical isolation layer. At least one of the first source/drain layer, the second source/drain layer, and the gate electrode of each of at least one of the semiconductor devices is in contact with and thus electrically connected to the conductive structure at a corresponding height in the interconnection structure in a lateral direction.

According to another aspect of the present disclosure, a method of manufacturing a semiconductor apparatus is provided, including: providing a stack on a substrate, wherein the stack includes one or more device layers, and each device layer includes a first source/drain layer, a channel defining layer, and a second source/drain layer that are sequentially stacked; patterning the stack as a column for defining an active region; forming a channel layer based on the channel defining layer, wherein the channel layer is relatively recessed in a lateral direction with respect to the first source/drain layer and the second source/drain layer; forming a gate electrode in a recess of the channel layer with respect to the first source/drain layer and the second source/drain layer; forming an interconnection structure around the column, wherein the interconnection structure includes an electrical isolation layer and a conductive structure in the electrical isolation layer. The method further includes controlling a height of the conductive structure in the interconnection structure, so that at least one of the first source/drain layer, the second source/drain layer, and the gate electrode of each of at least one of semiconductor devices is in contact with and thus electrically connected to the conductive structure at a corresponding height in the lateral direction.

According to another aspect of the present disclosure, an electronic device is provided, including the above-mentioned semiconductor apparatus.

According to embodiments of the present disclosure, for an array of vertical semiconductor devices, a sidewall interconnection structure laterally adjacent thereto may be provided, which may reduce a photolithography step in a manufacturing process and reduce a manufacturing cost. A manufacturing process step may be shared between stacked vertical semiconductor devices, so that the manufacturing cost may be reduced. In addition, a three-dimensional configuration may allow for more space for the interconnection between devices and thus may have a low resistance and a high bandwidth. Due to an existence of the sidewall interconnection structure, the semiconductor apparatus may have a leading-out terminal. Therefore, a manufacturing of the semiconductor apparatus may be separated from a manufacturing of a metallized stack, so that a chip similar to a Field Programmable Gate Array (FPGA) may be obtained.

### BRIEF DESCRIPTION OF THE DRAWINGS

The above and other objectives, features, and advantages of the present disclosure will be more apparent through the following description of embodiments of the present disclosure with reference to the accompanying drawings, in which:
FIG. 1 to FIG. 33 schematically show some stages in a process of manufacturing a semiconductor apparatus, in particular an interconnection structure therein, according to an embodiment of the present disclosure; and
FIG. 34 to FIG. 36 schematically show some stages in a process of manufacturing a semiconductor apparatus, in particular an interconnection structure therein, according to another embodiment of the present disclosure, in which

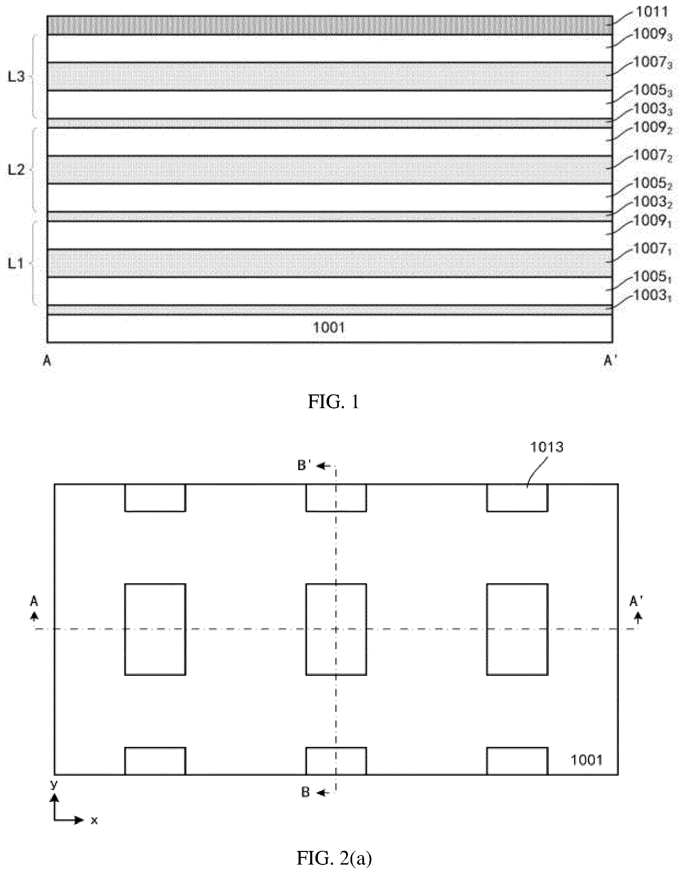

FIGS. 2(a) (in which positions of line AA' and line BB' are shown), 2(b), 3(a), 4(a), 5(a), 12, 16(a) (in which positions of line CC 'and line DD' are shown), and 17(a) are top views,
FIGS. 1, 2(c), 5(b), 6 to 11, 13 to 15, and 34 to 36 are cross-sectional views taken along line AA',

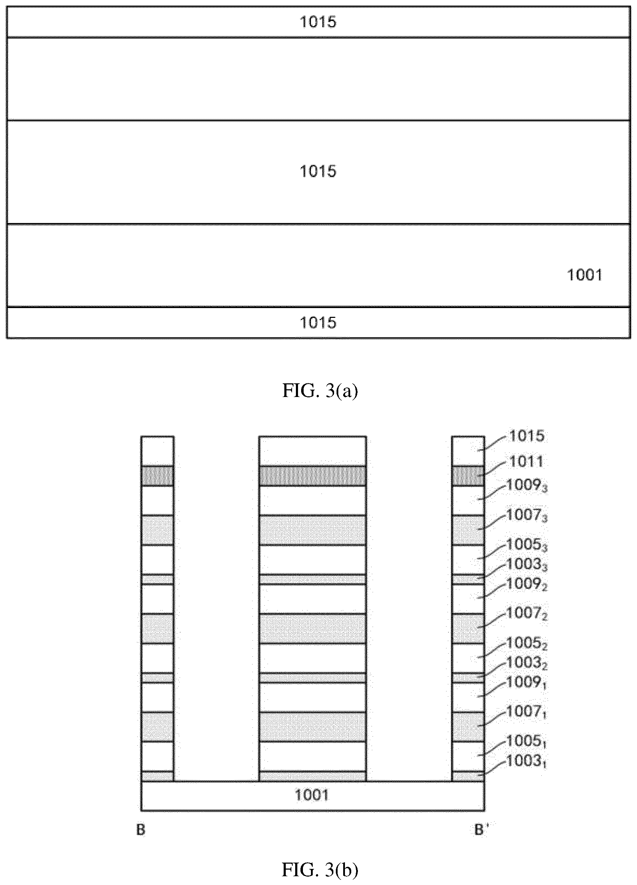

FIGS. 3(b), 4(b), and 5(c) are cross-sectional views taken along line BB',

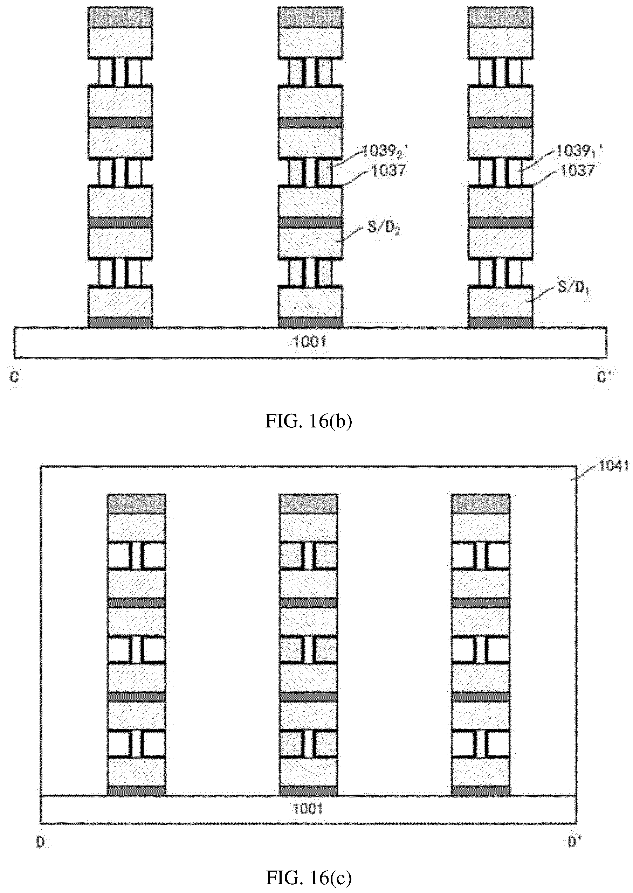

FIGS. 16(b), 17(b), 18(a), 19, 20(a), 21 to 27, 28(a), 31(b), 32(a), and 33 are cross-sectional views taken along line CC', and
FIGS. 16(c), 17(c), 18(b), 20(b), 28(b), 29, 30, 31(a), and 32(b) are cross-sectional views taken along line DD'.

Throughout the accompanying drawings, the same or similar reference signs represent the same or similar components.

### DETAILED DESCRIPTION OF EMBODIMENTS

Embodiments of the present disclosure will be described below with reference to accompanying drawings. It should be understood, however, that the descriptions are merely exemplary, and are not intended to limit the scope of the present disclosure. In addition, in the following descriptions, descriptions of well-known structures and techniques are omitted to avoid unnecessarily obscuring the concepts of the present disclosure.

Various schematic structural diagrams according to embodiments of the present disclosure are shown in the accompanying drawings. The figures are not drawn to scale. Some details are enlarged and some details may be omitted for clarity of presentation. The shapes of the various regions, layers as well as the relative size and positional relationship thereof shown in the figures are only exemplary. In practice, there may be deviations due to manufacturing tolerances or technical limitations, and those skilled in the art may additionally design regions/layers with different shapes, sizes, and relative positions according to actual needs.

In the context of the present disclosure, when a layer/element is referred to as being located "on" a further layer/element, the layer/element may be directly on the further layer/element, or there may be an intermediate layer/element therebetween. In addition, if a layer/element is located "on" a further layer/element in one orientation, the layer/element may be located "under" the further layer/element when the orientation is reversed.

According to embodiments of the present disclosure, a semiconductor apparatus with a sidewall interconnection structure is provided. Here, the so-called "sidewall" interconnection structure refers to that the interconnection structure is formed in a lateral direction (e.g., in a direction substantially parallel to a surface of a substrate) of a device requiring an interconnection, and thus may be interconnected to the device (e.g., a component requiring the interconnection in the device, such as a source/drain layer or a source/drain region formed therein, a gate electrode, etc.) through a sidewall of the device. The device may be a vertical device, so the source/drain layer and the gate electrode of the device may be at different heights (with respect to the substrate). Due to a difference in heights of the components requiring the interconnection, conductive structures interconnected to these components may be formed on the sidewalls of the components, respectively.

For example, the vertical device may include an active region disposed vertically (e.g., in a direction substantially perpendicular to a surface of a substrate) on the substrate, which may include, for example, a first source/drain layer, a channel layer, and a second source/drain layer stacked in a vertical direction. The channel layer may be a vertical nanosheet or nanowire. A source/drain region may be formed in the first source/drain layer and the second source/drain layer, and a channel region may be formed in the channel layer. The channel layer may contain a single crystal semiconductor material. Certainly, the source/drain layer may also contain a single crystal semiconductor material. For example, both the channel layer and the source/drain layer may be formed by an epitaxial growth.

The device may further include a gate electrode disposed on an outer periphery of the channel layer, and the gate electrode may surround the outer periphery of the channel layer. Therefore, a device according to embodiments of the present disclosure may be a gate-all-around device. According to embodiments of the present disclosure, the gate electrode may be self-aligned with the channel layer. For example, at least a portion of the gate electrode on a side close to the channel layer may be substantially coplanar with the channel layer. For example, the portion of the gate electrode may be substantially coplanar with an upper surface and/or a lower surface of the channel layer.

Accordingly, the first source/drain layer, the second source/drain layer, and the gate electrode may be at different heights. Therefore, an interconnection with the vertical device may be achieved through conductive structures at different heights in the interconnection structure.

Devices may be stacked on each other to form a device stack, so as to increase an integration density. A plurality of device stacks may be disposed on the substrate. The interconnection structure may be formed between the device stacks, so that devices requiring an interconnection in or between the device stacks may be electrically connected to each other. More specifically, (a sidewall of) the conductive structure in the interconnection structure is exposed and (the sidewall of) the component is also exposed at a position where the interconnection structure is adjacent to the component requiring an electrical connection, so that the two may be in contact with and therefore electrically connected to each other. The interconnection structure and the device may have an observable interface therebetween. In order to achieve an interconnection in all directions, the interconnection structure may surround each device stack. Certainly, a part of device stacks may be provided with the interconnection structure only on the sidewall requiring an electrical connection. For ease of layout, the device stacks may be arranged in an array.

The interconnection structure may include a conductive structure, such as an interconnection line and a via hole, disposed in an electrical isolation layer (e.g., a dielectric layer). For example, the interconnection structure may include an interconnection line layer and a via hole layer alternately disposed. An interconnection line may be provided in the interconnection line layer to achieve an interconnection in a same layer, and a via hole may be provided in the via hole layer to achieve an interconnection between different layers. The interconnection line may include a body portion extending in a corresponding interconnection line layer and a barrier layer surrounding the body portion.

The semiconductor apparatus may be manufactured as follows. For example, a stack of one or more device layers may be provided on the substrate, and each device layer may include a first source/drain layer, a channel defining layer, and a second source/drain layer sequentially stacked. A sacrificial layer may be provided as needed between adjacent device layers and/or between the device layer and the substrate. The stack may be formed by an epitaxial growth, so each layer may contain a single crystal semiconductor material.

The stack may be patterned as a column for defining an active region. For example, columns may be arranged in an array. The channel layer may be formed based on the channel defining layer. For example, the channel defining layer may be relatively recessed in a lateral direction by a selective etching, and an additional channel layer (which may contain a single crystal semiconductor material due to the epitaxial growth) may be grown on a sidewall of the channel defining layer. Alternatively, the channel layer may be formed by the (relatively recessed) channel defining layer itself.

The gate electrode may be formed around the channel layer. Since the channel layer is relatively recessed in the lateral direction, the gate electrode may be self-aligned with the channel layer.

When the sacrificial layer is provided, the sacrificial layer may be replaced with a device isolation layer. In a case that the sacrificial layer has an etching selectivity with respect to other layers in the stack, the sacrificial layer may be removed by the selective etching, and the device isolation layer may be formed by filling a gap left by a removal of the sacrificial layer with a dielectric material. During the replacement, the column may be maintained at least on a side through a supporting material.

If the sacrificial layer has no or little etching selectivity with respect to another layer (e.g., the channel defining layer) in the stack, it is required to form a protective layer for the another layer, such as the channel defining layer, before the sacrificial layer is replaced. For example, the channel defining layer may be relatively recessed in the lateral direction by the selective etching. Due to a low or even no etching selectivity, the sacrificial layer may also be relatively recessed in the lateral direction. A filling layer may be formed to eliminate the recess of the sacrificial layer, and the protective layer (hereinafter also referred to as a position retaining layer) may be formed in the recess of the channel defining layer. A filling layer that fills only the recess of the sacrificial layer and does not fill the recess of the channel defining layer may be formed by designing a thickness of each layer, which will be further described below in detail.

The source/drain layer and the gate electrode may be exposed at a sidewall of the column. The interconnection structure may be formed around the column so as to be interconnected with the source/drain layer and the gate electrode that are exposed at the sidewall of the column.

The conductive structure in the interconnection structure may be formed in layers so as to be connected to devices at different heights. For example, an interconnection line may be formed around the column (e.g., on the substrate or a part of the formed interconnection structure). The dielectric material may be filled to bury the interconnection line, and the via hole may be formed in the filled dielectric material. By repeatedly performing such an operation multiple times, an interconnection structure including a plurality of layers of interconnection lines and a plurality of layers of via holes may be formed. A height of the interconnection line and a height of the via hole may be controlled through a formation height of the dielectric material.

The present disclosure may be presented in various forms, some examples of which will be described below. In the following descriptions, a selection of various materials is involved. In the selection of materials, in addition to a function of the material (e.g., a semiconductor material may be used to form the active region, a dielectric material may be used to form an electrical isolation, and a conductive material may be used to form the interconnection line and the via hole), the etching selectivity is also considered. In the following description, a desired etching selectivity may or may not be indicated. It should be clear to those skilled in the art that when etching a material layer is mentioned below, if it is not mentioned or shown that other layers are also etched, then the etching may be selective, and the material layer may have an etching selectivity with respect to other layers exposed to the same etching recipe.

FIG. 1 to FIG. 33 schematically show some stages in a process of manufacturing a semiconductor apparatus, in particular an interconnection structure therein, according to an embodiment of the present disclosure.

As shown in FIG. 1, a substrate 1001 is provided. The substrate 1001 may be in various forms, including but not limited to a bulk semiconductor material substrate such as a bulk Si substrate, a semiconductor-on-insulator (SOI) substrate, a compound semiconductor substrate such as a SiGe substrate, and the like. The bulk Si substrate such as a silicon wafer is illustrated below by way of example.

A sacrificial layer 1003₁ for defining an isolation layer, a first source/drain layer 1005₁ for defining a lower source/drain region, a channel defining layer 1007₁ for defining a channel portion, and a second source/drain layer 1009₁ for defining an upper source/drain region may be formed on the substrate 1001 by, for example, an epitaxial growth. The first source/drain layer 1005₁, the channel defining layer 1007₁ and the second source/drain layer 1009₁ may then define the active region of the device, and may be referred to as a "device layer", which is denoted by L1 in FIG. 1.

The sacrificial layer 1003₁ may then be replaced with an isolation layer for isolating the device from the substrate, and may have a thickness corresponding to a desired thickness of the isolation layer, for example, about 10 nm to 20 nm. According to a circuit design, the sacrificial layer 1003₁ may be omitted. The first source/drain layer 1005₁ and the second source/drain layer 1009₁ may then be doped (or doped in situ during growth) to form the source/drain region, and may have a thickness of, for example, about 20 nm to 50 nm. The channel defining layer 1007₁ may define a gate length and may have a thickness corresponding to a desired gate length of, for example, about 15 nm to 100 nm. Taking into account the following process of replacing the sacrificial layer 1003₁ with the isolation layer, the thickness of the channel defining layer 1007₁ here may be greater than the thickness of the sacrificial layer 1003₁, which will be further described below in detail.

Each layer grown on the substrate 1001 may be a single crystalline semiconductor layer, and adjacent layers may have an etching selectivity therebetween. For example, the sacrificial layer 1003₁ may contain SiGe (an atomic percentage of Ge is, for example, about 10% to 30%, preferably 15%), the first source/drain layer 1005₁ may contain Si, the channel defining layer 1007₁ may contain SiGe (the atomic percentage of Ge is, for example, about 10% to 30%, preferably 15%), and the second source/drain layer 1009₁ may contain Si.

In order to increase an integration density, a plurality of device layers may be provided. For example, a device layer L2 and a device layer L3 may be sequentially disposed on the device layer L1 by an epitaxial growth, and the device layers may be separated from each other respectively by sacrificial layers 1003₂ and 1003₃ for defining the isolation layers. According to the circuit design, the isolation layer may be omitted between certain device layers. Similarly, the device layer L2 may include a first source/drain layer 1005₂, a channel defining layer 1007₂, and a second source/drain layer 1009₂. The device layer L3 may include a first source/drain layer 1005₃, a channel defining layer 1007₃, and a second source/drain layer 1009₃. Corresponding layers in each device layer may have the same or similar thickness and/or material, or may have different thicknesses and/or materials. In particular, the channel defining layers in different device layers may have different thicknesses, so that an electrical property of a resulting device may be adjusted. Here, for ease of description only, it is assumed that the device layers L1, L2 and L3 have the same configuration.

A hard mask layer 1011 may be provided on the layers formed on the substrate 1001, for convenience of patterning. For example, the hard mask layer 1011 may contain a nitride (e.g., silicon nitride) and have a thickness of about 50 nm to 200 nm.

Next, the active region may be defined in the device layers.

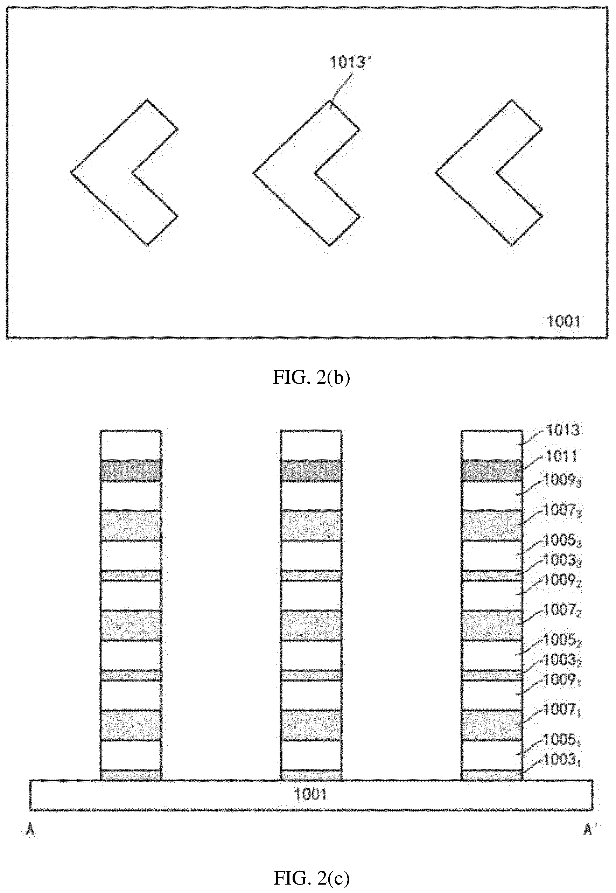

For example, as shown in FIG. 2(a), a photoresist 1013 may be formed on the hard mask layer 1011 and may be patterned into a shape of the active region by photolithography. In the example of FIG. 2(a), the photoresist 1013 is patterned in the form of an array arranged in a x-direction and a y-direction, and each element in the array is substantially in a shape of a rectangle (which may be a column to define the active region of an individual device), such as a rectangle with a short side in the x-direction and a long side in the y-direction. Certainly, the present disclosure is not limited to this. The photoresist 1013 may be patterned into various suitable shapes. For example, as shown in FIG. 2(b), in order to prevent a columnar active region from collapsing during manufacturing, the element in the array may be in a zigzag shape. For convenience, a case shown in FIG. 2(a) is illustrated by way of example in the following description.

The layers on the substrate 1001 may be sequentially etched by selective etching such as Reactive Ion Etching (RIE) with the patterned photoresist 1013 as an etching mask. The RIE may be performed in a substantially vertical direction (e.g., a direction perpendicular to the surface of the substrate) and may stop on a surface of the substrate 1001. Accordingly, an array of a series of columns is left on the substrate 1001, as shown in FIG. 2(c). Each column may define the active regions of a plurality of (which is three in the example) vertical devices stacked on each other. In top view, each column may have a rectangular shape as shown in FIG. 2(a) or a zigzag shape as shown in FIG. 2(b). After that, the photoresist 1013 may be removed.

The device will be manufactured below on the basis of the active regions. Taking into account a requirement of the following process, such as a control of a topography of the channel layer, a shielding material may be formed around the column. During a manufacturing process, one or more sides of the active region may be exposed so that the active region may be processed, while the other side or sides of the active region may be shielded by the shielding material. The shielding material may further support an elongate column during the manufacturing process, particularly during a process of replacing the sacrificial layer with the isolation layer, so as to prevent a collapse of the elongate column.

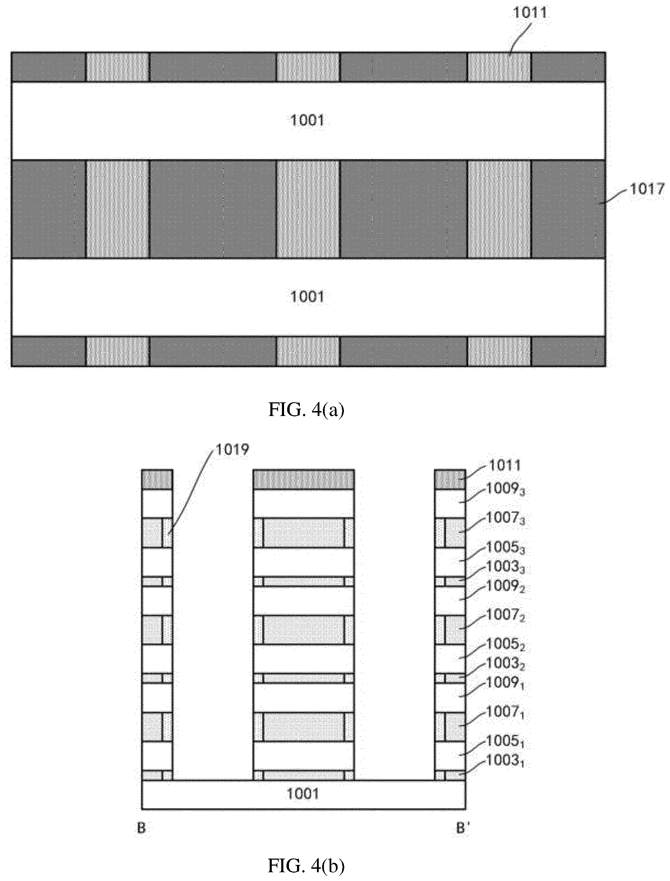

For example, as shown in FIG. 3(a) and FIG. 3(b), the shielding material (referring to 1017 in FIG. 4(a)) may be formed by, for example, a deposition on the substrate 1001. Taking into account the etching selectivity (e.g., an etching selectivity with respect to the hard mask layer 1011 such as a nitride and a subsequently formed position retaining layer such as an oxide (e.g., silicon oxide)), the shielding material 1017 may contain SiC. A planarization process such as a Chemical Mechanical Polishing (CMP) may be performed on the deposited shielding material 1017, and the CMP may stop on the hard mask layer 1011. Accordingly, each column may be surrounded by the shielding material 1017.

Here, in order to control a length of the subsequently formed channel layer in the y-direction and a topography of an end portion of the channel layer in the y-direction, two opposite sides of the active region in the y-direction may be processed firstly. Accordingly, both sides need to be exposed. To this end, a photoresist 1015 may be formed on the hard mask layer 1011 and the shielding material 1017, and may be patterned to at least expose two opposite sides of each column in the y-direction. For example, the photoresist 1015 may include an opening extending in the x-direction between the columns. The shielding material 1017 may be etched by a selective etching such as RIE, with the patterned photoresist 1015 as an etching mask. The RIE may be performed in a substantially vertical direction and may stop on the surface of the substrate 1001. Accordingly, a sidewall of each column in the y-direction may be exposed (referring to FIG. 3(b)), and a sidewall of each column in the x-direction is at least partially shielded (depending on a size of the opening in the photoresist 1015 in the y-direction) by the shielding material 1017 (referring to FIG. 4(a)). After that, the photoresist 1015 may be removed.

In order to form a self-aligned gate stack, a gap (which may be referred to as a "gate gap") for forming the gate stack may be defined based on the channel defining layer. For example, as shown in FIG. 4(a) and FIG. 4(b), the exposed sidewalls of the channel defining layers 1007₁, 1007₂ and 1007₃ may be selectively etched to be relatively recessed (with respect to the upper and lower source/drain layers). In order to achieve a good etching control, Atomic Layer Etching (ALE) may be used here. Accordingly, for each of the device layers L1, L2, L3, a gap (i.e., the gate gap) may be defined between the upper and lower source/drain layers. The gap is originally occupied by the channel defining layer, and thus may be self-aligned with the channel defining layer. The gate gaps on two opposite sides of the channel defining layer in the y-direction may have substantially a same dimension (heights in the vertical direction may correspond to the thickness of the channel defining layer, and widths in the y-direction may be substantially equal to each other).

The etching recipe may exhibit substantially the same etching degree for the channel defining layers 1007₁, 1007₂ and 1007₃, so that the sidewalls of the channel defining layers 1007₁, 1007₂ and 1007₃ may be substantially aligned or substantially coplanar with each other in the vertical direction after etching. In addition, the sacrificial layers 1003₁, 1003₂ and 1003₃ containing SiGe (same as the channel defining layer) may also be etched to be relatively recessed, and therefore form corresponding gaps (which may be referred to as "isolation gaps").

In the formed gate gap, in order to prevent a subsequent processing from remaining a material in the gate gap so as to affect a formation of the gate stack, the gate gap may be filled with a first position retaining layer 1019 (which may also be referred to as a "sacrificial gate"). For example, the gate gaps may be filled with the first position retaining layer 1019 such as an oxide by deposition and then etching back (e.g., RIE). Similarly, the isolation gap may also be filled with the first position retaining layer 1019.

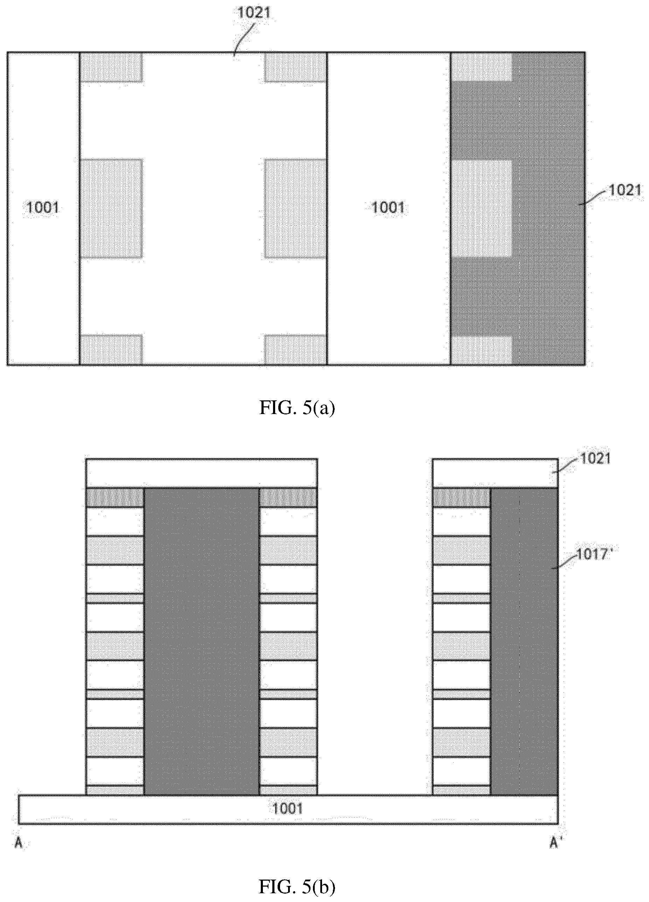

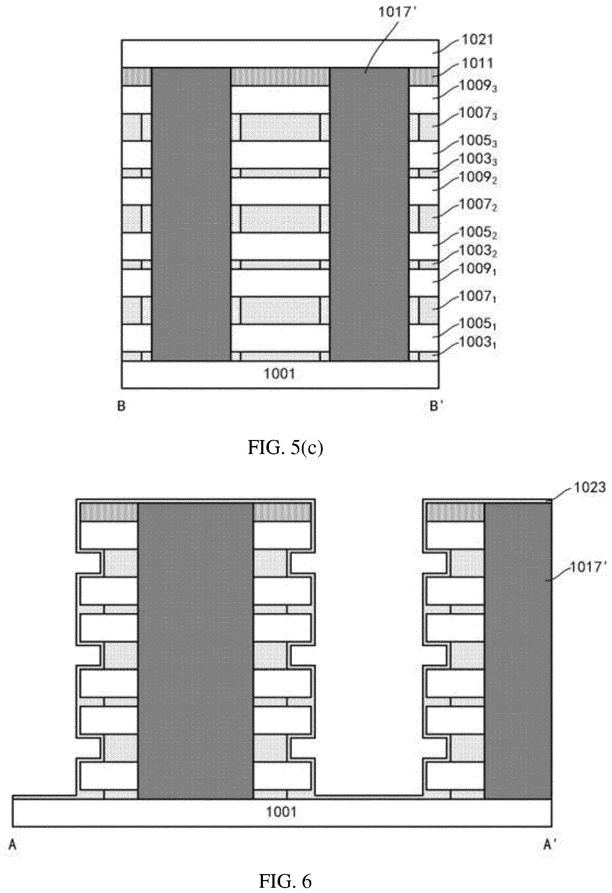

Then, the two opposite sides of the active region in the x-direction may be processed. Similarly, a shielding material may be formed firstly, and then may be patterned to expose the two sides to be processed. For example, as shown in FIG. 5(a), FIG. 5(b) and FIG. 5(c), the shielding material may be formed on the substrate 1001 by a process such as deposition and planarization. For convenience of a subsequent etching process, the shielding material formed here may contain the same material, such as SiC, as the previous shielding material 1017, and thus may be shown as 1017' integrally with the previous shielding material 1017. Then, the shielding material 1017' may surround each column.

When exposing the two opposite sides in the x-direction, the two sides may be separately processed taking into account a supporting function required in the replacement of the isolation layer.

For example, a photoresist 1021 may be formed and may be patterned to expose a side of each column in the x-direction. For example, the photoresist 1021 may include an opening extending in the y-direction between each pair of adjacent columns. The shielding material 1017' may be etched by the selective etching such as RIE, with the patterned photoresist 1021 as an etching mask. The RIE may be performed in a substantially vertical direction and may stop on the surface of the substrate 1001. Accordingly, a sidewall of each column in the x-direction may be exposed, and the sidewalls in the y-direction may be at least partially (depending on a size of the opening in the photoresist 1021 in the x-direction) shielded and the other sidewall in the x-direction may be shielded, by the shielding material 1017'. After that, the photoresist 1021 may be removed.

Processing similar to that in FIG. 4(a) and FIG. 4(b) may be performed on the currently exposed sidewall of each column, so as to define the gate gap. For example, as shown in FIG. 6, the exposed sidewalls of the channel defining layers 1007₁, 1007₂ and 1007₃ may be selectively etched to be relatively recessed (with respect to the upper and lower source/drain layers). Similarly, ALE may be adopted. Accordingly, the gate gaps self-aligned with the channel defining layers may be formed. After that, the position retaining layers may be formed to fill the gate gaps.

Here, similarly, the sacrificial layers 1003₁, 1003₂ and 1003₃ may also be relatively recessed, so as to form the isolation gaps. In the processing described above in combination with FIG. 4(a) and FIG. 4(b), the isolation gap may also be filled with the position retaining layer, which may affect a subsequent replacement of the sacrificial layer. In order to prevent the position retaining layer from filling the isolation gap, the isolation gap may be fully filled firstly.

For example, a filling layer 1023 may be formed by an epitaxial growth. A growth thickness of the filling layer 1023 may be greater than half of a thickness of each of the sacrificial layers 1003₁, 1003₂, 1003₃, so that each isolation gap may be fully filled. In addition, the filling layer 1023 may not fully fill the gate gap (in which the position retaining layer or the sacrificial gate may be formed). To this end, on one hand, the thickness of the channel defining layer may be greater than the thickness of the sacrificial layer (the growth thickness of the filling layer 1023 may be less than half of the thickness of the channel defining layer) as described above. On the other hand, an etching depth of the channel defining layer when forming the gate gap is preferably greater than half of the thickness of the sacrificial layer (the growth thickness of the filling layer 1023 may be less than the etching depth of the channel defining layer). Accordingly, the filling layer 1023 may fully fill each isolation gap without fully filling each gate gap, as shown in FIG. 6.

A material of the filling layer 1023 may have a similar or substantially the same etching selectivity as a material of the sacrificial layer, so that the filling layer 1023 may be subsequently removed along with the sacrificial layer by the same etching recipe. For example, the filling layer 1023 may contain SiGe, with an atomic percentage of Ge of about 10% to 40%, for example.

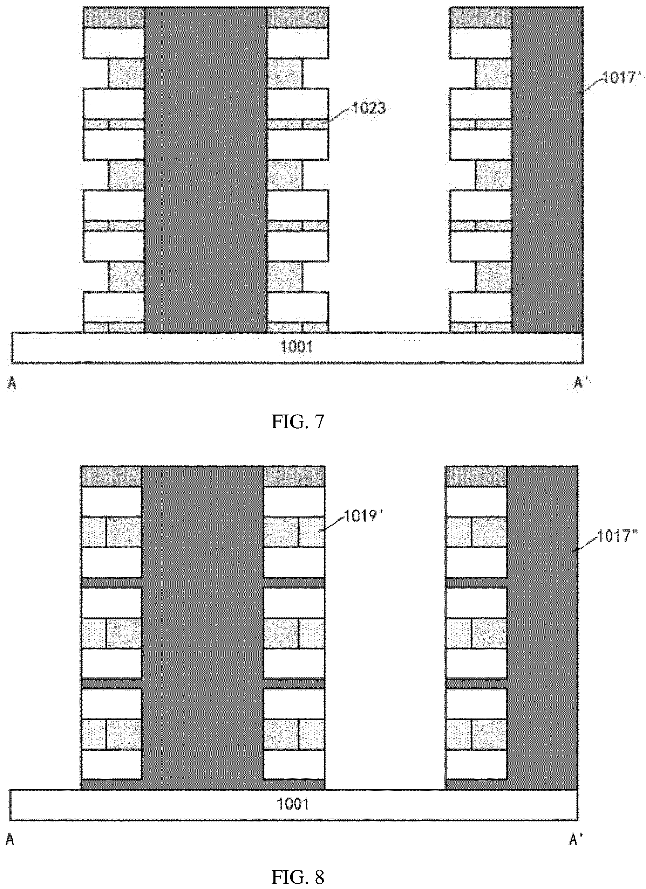

After that, as shown in FIG. 7, the filling layer 1023 of a certain thickness may be removed by the selective etching. For example, a removal thickness may be substantially equal to or slightly greater than the growth thickness of the filling layer 1023. Accordingly, the filling layer 1023 may be removed from the gate gap and left in the isolation gap. In order to control the removal thickness well, the ALE may be used.

Then, as shown in FIG. 8, a second position retaining layer 1019' may be formed as described above. A material of the second position retaining layer 1019' may have a similar or substantially the same etching selectivity as a material of the first position retaining layer 1019, so that the second position retaining layer 1019' may be subsequently removed along with the first position retaining layer 1019 by the same etching recipe. For example, the second position retaining layer 1019' may contain an oxide.

In the above-mentioned embodiments, the first position retaining layer 1019 and the second position retaining layer 1019' are formed in different steps, which may help control the length of the subsequently grown channel layer in the y-direction and the topography of the end portion of the subsequently grown channel layer in the y-direction. However, the present disclosure is not limited to this. The first position retaining layer 1019 and the second position retaining layer 1019' may also be formed in the same step, particularly in a case of forming the channel layer by using the channel defining layer. For example, the two opposite sides of each channel defining layer in the y-direction and a side of the channel defining layer in the x-direction (the other side of the channel defining layer in the x-direction may be shielded by the shielding material) may be selectively etched to be relatively recessed, and the position retaining layer may be formed in the gap thus obtained.

Currently, each channel defining layer is surrounded by the shielding material, the position retaining layer and the source/drain layer, while a sidewall of the filling layer 1023 is exposed. The filling layer 1023 and the sacrificial layer exposed by the removal of the filling layer 1023 may be removed by the selective etching. The etching may stop on the shielding material 1017'. In this way, the sacrificial layer may be removed between the device layers (while each device layer is still retained by the shielding material 1017'). A gap left by the removal of the sacrificial layer may be filled with a dielectric material to form an isolation layer by a process such as deposition (e.g., Chemical Vapor Deposition (CVD), Atomic Layer Deposition (ALD), etc.) and then etching back (e.g., RIE). A suitable dielectric material, such as an oxide, a nitride, SiC or a combination thereof, may be selected for various purposes, such as optimizing an isolation reliability, a leakage current or a capacitance, etc. Accordingly, the device layers may be isolated from each other. Here, for ease of description only, the filled dielectric material may contain SiC, and thus may be shown as 1017" integrally with the shielding material 1017'.

Next, the channel layer may be formed.

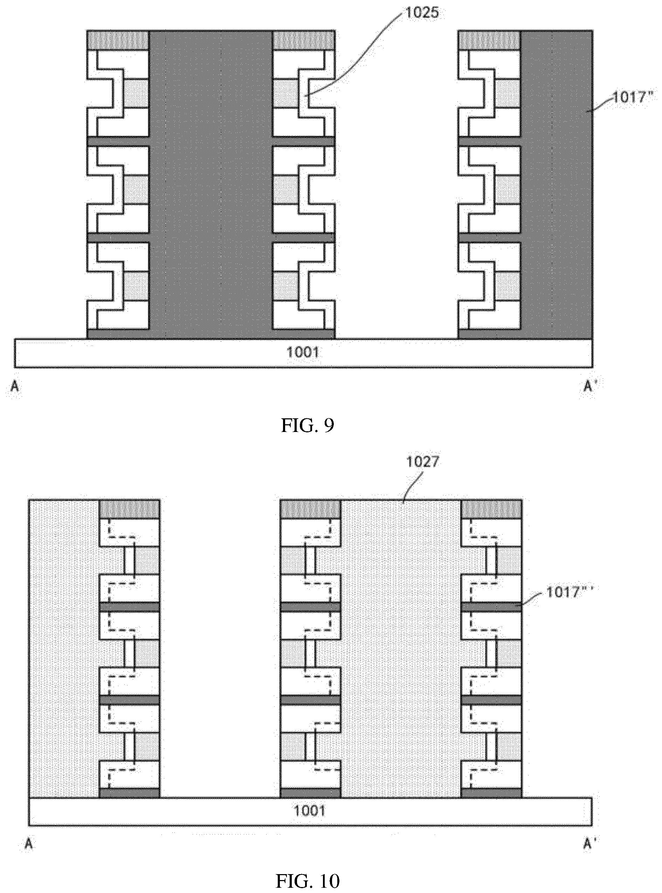

For example, as shown in FIG. 9, the position retaining layer 1019' may be removed by the selective etching. Here, the position retaining layer 1019 may be retained due to being covered by a shielding material 1017". Accordingly, a gate gap occupied by the position retaining layer 1019' may be released. In the released gate gap, a semiconductor layer may be formed by a selective epitaxial growth. The semiconductor layer may be grown along a surface of the channel defining layer and a surface of the source/drain layer. For convenience of illustration and description only, a portion of the semiconductor layer located on the sidewall of the channel defining layer will be separately shown below and referred to as a channel layer 1025 (a channel portion may be mainly formed in this portion), and a portion of the semiconductor layer located on the surface of the source/drain layer may be integrally shown with the source/drain layer and referred to as a source/drain layer (in which a source/drain region may be formed) (referring to a dotted line in FIG. 10). The channel layer 1025 may be formed on a sidewall (a sidewall that is originally covered by the position retaining layer 1019') of the channel defining layer in the x-direction. The channel layers 1025 in the device layers may be substantially aligned or substantially coplanar with each other in the vertical direction.

In the embodiments, in order to make both sides of the channel layer 1025 have substantially a same gate length, the channel defining layer and the source/drain layer may be etched back by a certain thickness before growing the semiconductor layer. A growth thickness of the semiconductor layer may be selected to be approximately equal to the etched thickness of the source/drain layer, so that a height of the gate gap after growing the semiconductor layer may be substantially the same as the thickness of the channel defining layer. A material of the channel layer 1025 may be selected to achieve a desired device performance. For example, the channel layer 1025 may contain a same material as the source/drain layer, such as Si, or may contain a material different from the material of the source/drain layer, such as SiGe.

In this embodiment, the channel layer 1025 may be grown additionally, which may help control a thickness of the channel layer 1025, and a subsequent selective etching may be easily controlled. Accordingly, a dual precise control of a thickness and a gate length of the channel layer may be achieved without the help of photolithography and selective ALE. However, the present disclosure is not limited to this. For example, the channel portion may be formed directly by using the channel defining layer.

Next, the other side of each column in the x-direction may be processed.

For example, as shown in FIG. 10, a further shielding material 1027 may be formed on the substrate 1001 by a process such as deposition and then planarization. A gap between the shielding materials 1017" on the substrate 1001 may be filled with the further shielding material 1027. In order to remove the shielding material 1017" and expose a side to be processed, the further shielding material 1027 may contain a material having an etching selectivity with respect to the shielding material 1017", such as an oxide. After that, a selective etching such as RIE may be performed on the shielding material 1017". The RIE may be performed in a substantially vertical direction, and may stop on the substrate 1001. Accordingly, a portion of the shielding material 1017" located below the hard mask layer may be left (forming an isolation layer and shown as 1017‴), and the other portion of the shielding material 1017" may be removed. In this way, the other side of the channel defining layer in the x-direction may be exposed (although the shielding material 1017" on two sides in the y-direction is also removed, two opposite sides of the channel layer 1025 in the y-direction may be shielded due to an existence of the position retaining layer 1019).

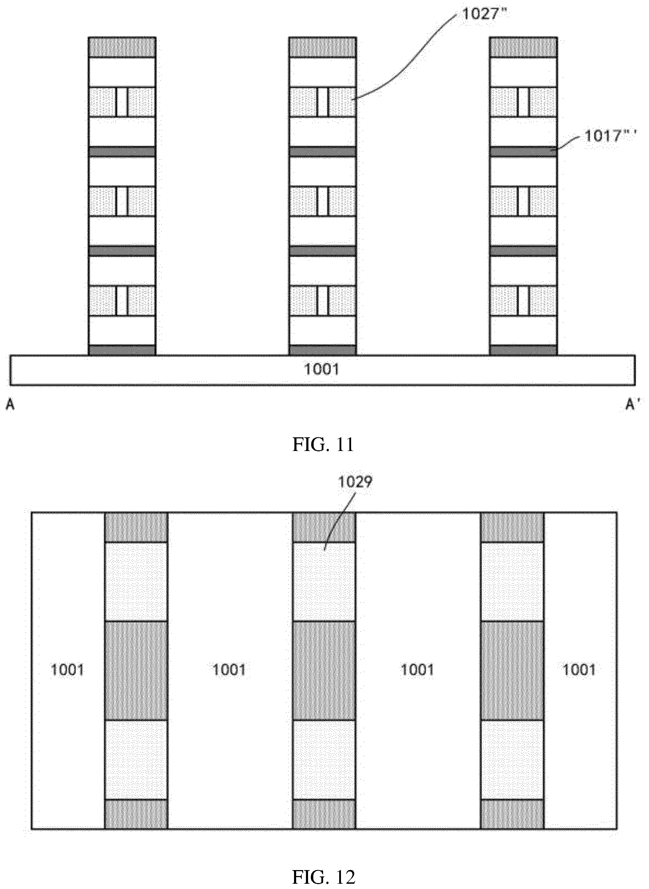

The gate gap may also be defined on the side currently exposed in the x-direction. For example, as shown in FIG. 11, the selective etching may be performed on the channel defining layers 1007₁, 1007₂ and 1007₃. Similarly, the ALE may be used. Here, the etching of the channel defining layer may stop on the channel layer 1025, so that the channel layer 1025 may be left between the upper and lower source/drain layers. Accordingly, the gate gap may be formed. Gate gaps on the two opposite sides of the channel layer 1025 in the x-direction may have substantially a same dimension (heights in the vertical direction may correspond to the thickness of the channel defining layer, and widths in the x-direction may be substantially equal to each other).

In a case that the channel layer 1025 is not grown additionally and the channel portion is formed by using the channel defining layers 1007₁, 1007₂ and 1007₃, the gate gap may be similarly formed around the channel defining layers 1007₁, 1007₂ and 1007₃. For example, the channel defining layers 1007₁, 1007₂ and 1007₃ may leave a residual portion like the channel layer 1025 by the selective etching such as ALE.

In the gate gap thus formed, a third position retaining layer 1027" may be similarly formed. For example, the third position retaining layer 1027" may be formed by deposition and then etching back (e.g., RIE) an oxide. The RIE may be performed in a substantially vertical direction and may stop on the surface of the substrate 1001.

As shown in FIG. 11, a plurality of columns arranged in an array (e.g., in the form shown in FIG. 2(a) or FIG. 2(b)) are formed on the substrate 1001. A plurality of device layers are stacked in each column. Each device layer may include a first source/drain layer, a second source/drain layer, and a channel layer between the first source/drain layer and the second source/drain layer. A gate gap may be formed around the channel layer, and the gate gap may be occupied by the position retaining layer. The gate gap is self-aligned with the channel layer. The device layers are isolated from each other by the isolation layer.

Currently, the sidewall of each source/drain layer is exposed to the outside. A source/drain region may be formed by doping the source/drain layer through the exposed sidewalls.

In the embodiment shown in FIG. 11, the hard mask layer 1011 serves as a mask during an etching-back process when forming the third position retaining layer 1027". Accordingly, opposite sidewalls of each source/drain layer in each of the x-direction and the y-direction are exposed to the outside, so that doping may be performed through each of the sidewalls. According to another embodiment of the present disclosure, as shown in FIG. 12, during the etching-back process when forming the third position retaining layer 1027", a photoresist 1029 may be additionally formed, and the photoresist 1029 may be patterned to shield the opposite sidewalls of each column in the y-direction. Accordingly, in addition to occupying the gate gap, the formed third position retaining layer 1027" may further shield the opposite sidewalls of each column in the y-direction. In this way, the doping may be performed through the sidewall of each source/drain layer in the x-direction, so that a change in doping characteristics caused by a difference in widths of the gate gaps on the two opposite sides in the x-direction and the gate gaps on the two opposite sides in the y-direction may be suppressed.

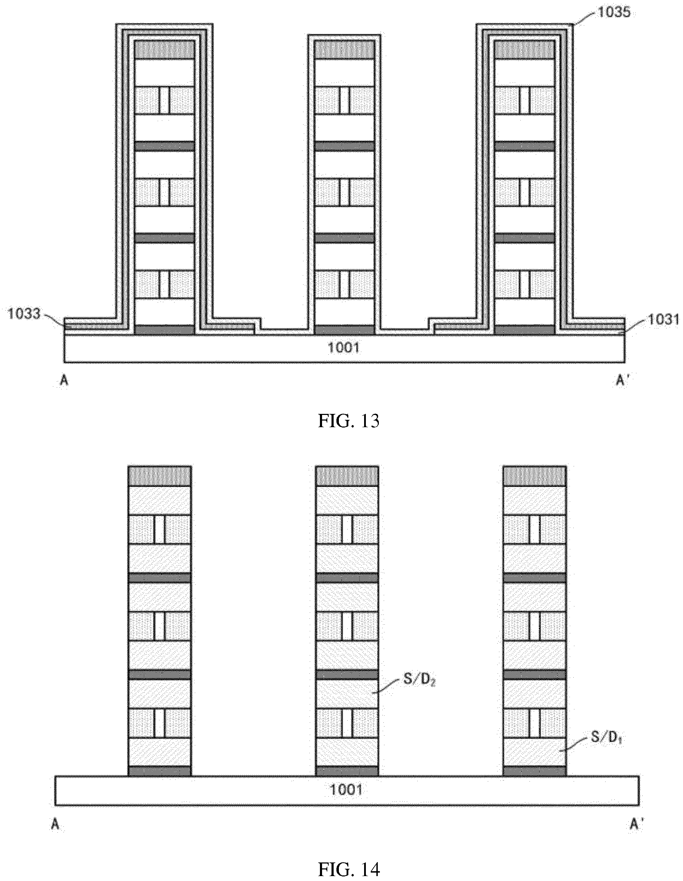

In order to perform the doping, as shown in FIG. 13, a dopant source layer may be formed on the surface of each column by, for example, deposition. The dopant source layer may be formed in a substantially conformal manner. Here, a formation of two types (n-type and p-type) of devices is taken as an example for description, and therefore n-type doping and p-type doping are required. For example, an n-type dopant source layer 1031 may be formed firstly, and may be patterned to cover a column in which the n-type device is to be formed. Then, a p-type dopant source layer 1035 may be formed. In order to avoid an interdiffusion between the n-type dopant source layer 1031 and the p-type dopant source layer 1035, a diffusion barrier layer 1033 may be formed therebetween. For example, the diffusion barrier layer 1033 may be formed on the n-type dopant source layer 1031 and may be patterned along with the n-type dopant source layer 1031. The n-type dopant source layer 1031 may contain an n-type dopant, such as a P-doped or As-doped oxide. A concentration of the n-type dopant may be about 0.1% to 10%, and a thickness of the n-type dopant may be about 1 nm to 10 nm. Similarly, the p-type dopant source layer 1035 may contain a p-type dopant, such as a B-doped oxide. A concentration of the p-type dopant may be about 0.1% to 10%, and a thickness of the p-type dopant may be about 1 nm to 10 nm. The diffusion barrier layer 1033 may contain a nitride, and have a thickness of about 2 nm to 10 nm.

Then, as shown in FIG. 14, the dopant may be driven into the source/drain layer from the dopant source layer by, for example, an annealing process, so as to form the source/drain region in the source/drain layer. Here, an n-type source/drain region S/D1 and a p-type source/drain region S/D2 are shown. The substrate 1001 may also be doped. The position retaining layer may prevent the dopant from directly entering the channel layer 1025. Certainly, a small amount of dopant entering via the source/drain layer may exist at an end portion of the channel layer 1025 close to the source/drain layer. After that, the n-type dopant source layer 1031, the p-type dopant source layer 1035, and the diffusion barrier layer 1033 may be removed.

In this example, the source/drain layers in each column are doped to the same conductivity type. However, the present disclosure is not limited to this. For example, the source/drain layers in different device layers in each column may be doped to different conductivity types through an appropriate design of the dopant source layer.

In the embodiments, a surface of the source/drain layer may be silicified to reduce a contact resistance. For example, a metal such as NiPt may be formed on the surface of each column and an annealing may be performed, so that the metal may react with Si in the source/drain layer to form a metal silicide such as NiPtSi. After that, an unreacted metal may be removed.

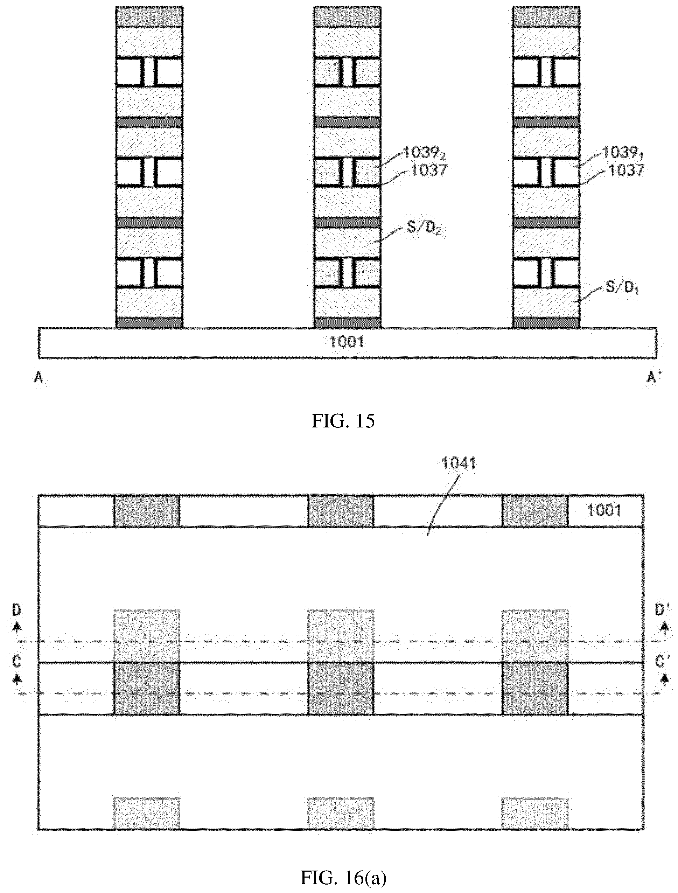

Next, a replacement gate process may be performed to replace the position retaining layer with a gate stack. For example, as shown in FIG. 15, the position retaining layers 1019 and 1027" may be removed by selective etching, so as to release the gate gap. A gate dielectric layer 1037 may be formed in a substantially conformal manner by, for example, deposition such as ALD. A gate conductor layer may be formed on the gate dielectric layer 1037 by, for example, deposition such as ALD. Here, firstly forming a gate conductor layer 1039₁ of an n-type device is taken as an example for description. The gate gap may be fully filled with the deposited gate conductor layer 1039₁. A portion of the gate conductor layer 1039₁ outside the gate gap may be removed by etching back such as RIE, so that the gate conductor layer 1039₁ may be left in the gate gap. Then, the n-type device may be covered and the p-type device may be exposed by using, for example, a photoresist. The gate conductor layer 1039₁ formed in the gate gap of the p-type device may be removed by the selective etching, so as to release the gate gap thereof. A gate conductor layer 1039₂ of the p-type device may be similarly formed in the gate gap of the p-type device. The gate dielectric layer 1037 may include a high-k gate dielectric such as HfO_{2,} and the gate conductor layers 1039₁ and 1039₂ may include a metal gate conductor with a corresponding work function. Here, the n-type device and the p-type device may have the same gate dielectric layer 1037. However, the present disclosure is not limited thereto. For example, the n-type device and the p-type device may have different gate dielectric layers. In addition, an order of forming the gate conductor layer may be interchanged.

In this way, a vertical device is formed in each device layer of each column. Each vertical device may include a channel layer 1025, and first and second source/drain layers located on upper and lower sides of the channel layer 1025. The gate stack (a stack of the gate dielectric layer and the gate conductor layer) may surround the channel layer 1025 and may be self-aligned with the channel layer 1025. Each column may be referred to as a device stack. The substrate 1001 may be relatively recessed as a groove between the device stacks.

Currently, the sidewalls of the components requiring an electrical connection in each device, such as the gate conductor layer (which may also be referred to as a gate electrode) and the source/drain region (or a silicide formed on the surface thereof), are exposed to the outside. Accordingly, an interconnection structure laterally adjacent to each device may be formed to interconnect the devices in each device stack. Here, since the interconnection structure is laterally adjacent to the device and is in contact with the sidewalls of the components requiring an electrical connection in the device, the interconnection structure may be referred to as a sidewall interconnection structure.

In addition, in order to avoid an undesired electrical short circuit when forming the interconnection structure, conductive structures at different heights may be connected to the devices on different sides. For example, a first component requiring an electrical connection at a height in the device may be connected to a conductive structure in the interconnection structure on a first side, while a second component requiring an electrical connection that is adjacent to the first component in the vertical direction may be connected to a conductive structure in the interconnection structure on a second side (e.g., a side opposite to the first side) different from the first side. In addition, a sidewall of the first component on the second side may be covered by an isolation layer, and a sidewall of the second component on the first side may be covered by an isolation layer, so as to avoid a short circuit.

Embodiments of forming the isolation layer will be described below.

For example, as shown in FIG. 16(a), FIG. 16(b) and FIG.16(c), a photoresist 1041 may be formed on the substrate 1001, and may be patterned to shield a side (an upper side in the y-direction in FIG. 16(a)) of each device stack and expose the other side (a lower side in the y-direction in FIG. 16(a)) of each device stack. The gate conductor layer may be recessed relatively by a depth of, for example, about 5 nm to 20 nm, on the exposed side of each device stack by the selective etching, so as to release some gate gaps. A self-aligned isolation layer may be subsequently formed in the gate gaps. After that, the photoresist 1041 may be removed.

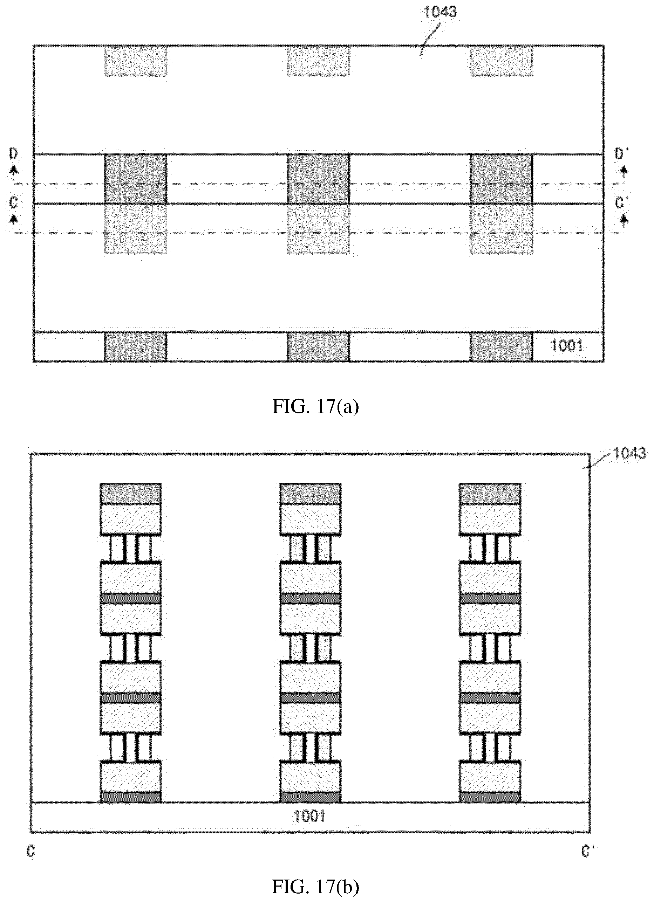

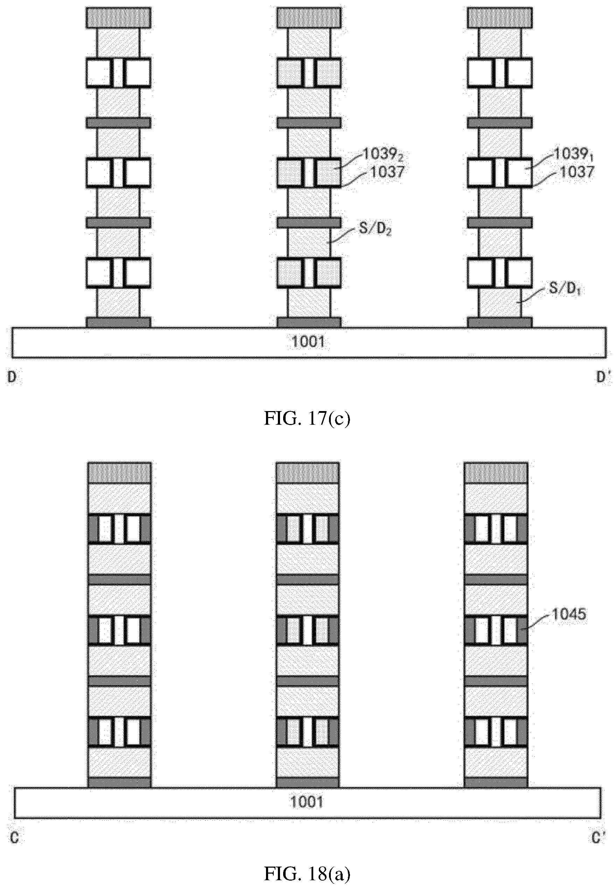

Then, as shown in FIG. 17(a), FIG. 17(b) and FIG.17(c), a photoresist 1043 may be formed on the substrate 1001, and may be patterned to shield a side (a lower side in the y-direction in FIG. 17(a)) of each device stack and expose the other side (an upper side in the y-direction in FIG. 17(a)) of each device stack. The source/drain layer may be recessed relatively by a depth of, for example, about 5 nm to 20 nm (which may be the same as the depth of the previously released gate gap, so that the subsequently filled isolation layer may have approximately the same thickness) on the exposed side of each device stack by the selective etching, so as to release some spaces. A self-aligned isolation layer may be subsequently formed in the spaces. After that, the photoresist 1043 may be removed.

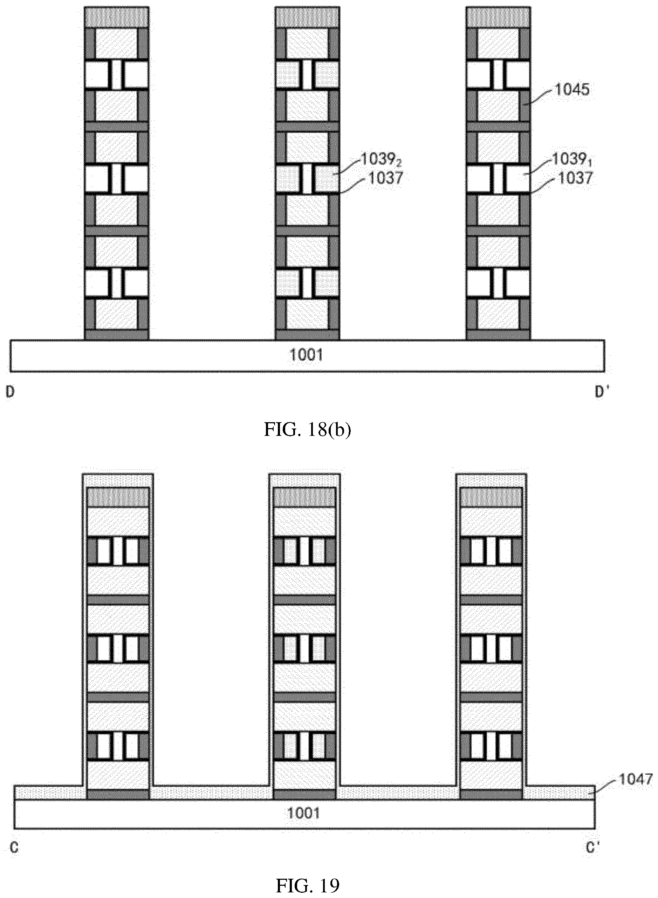

Accordingly, in each device stack, the source/drain layer may protrude relatively on a side, while the gate conductor layer may protrude relatively on the other side. The isolation layer may be formed in respective opposite recesses. For example, as shown in FIG. 18(a) and FIG. 18(b), the recesses may be filled with an isolation layer 1045 by a process of deposition and then etching back. Taking into account an etching selectivity with respect to a subsequently formed interlayer dielectric layer, the isolation layer 1045 may contain a dielectric material such as SiC. The isolation layers 1045 in different device layers may be substantially aligned or substantially coplanar with each other in the vertical direction.

Next, the interconnection structure may be manufactured. When manufacturing an interconnection line in the interconnection structure, in order to avoid a difficulty in etching a groove and then filling the groove with a conductive material such as a metal in a conventional process, a conductive structure may be formed firstly and then a dielectric material is filled according to embodiments of the present disclosure.

The lowermost of the current device stack is the first source/drain layer or the source/drain region of the device layer L1. A conductive structure for the first source/drain layer may be formed firstly.

Taking into account an electrical isolation from the substrate 1001 and a matching in height with the first source/drain layer, an electrical isolation layer of a certain thickness may be firstly formed in the groove between the device stacks, so that the conductive structure subsequently formed on the electrical isolation layer may be located at a height corresponding to the first source/drain layer and thus may be laterally adjacent to the first source/drain layer. In addition, it is desired that the electrical isolation layer thus formed may expose the sidewall of each device stack, so as to avoid affecting an electrical contact with the sidewall interconnection structure.

For example, the electrical isolation layer may be formed by the following method. As shown in FIG. 19, a preliminary isolation layer 1047 may be formed by depositing a dielectric material such as an oxide. In order to form the above-mentioned electrical isolation layer, the preliminary isolation layer 1047 may be formed to include a thick laterally extending portion and a thin vertically extending portion, which may be achieved by, for example, a High Density Plasma (HDP) deposition. Here, a thickness of the thick portion of the preliminary isolation layer 1047 may be about 20 nm to 150 nm.

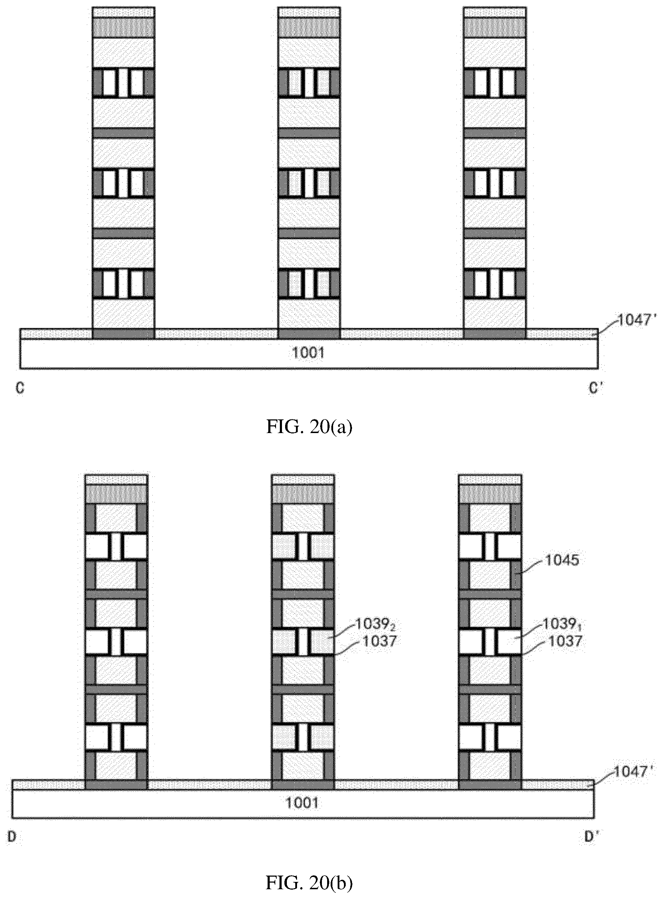

Then, as shown in FIG. 20(a) and FIG. 20(b), the preliminary isolation layer 1047 may be isotropically etched by a thickness, so that the vertically extending portion of the preliminary isolation layer 1047 may be removed while the laterally extending portion of the preliminary isolation layer 1047 may be left. For example, the left portion of the preliminary isolation layer 1047 may have a thickness of about 15 nm to 100 nm. Accordingly, the preliminary isolation layer 1047 may be left in the groove between the isolation devices (a portion of the preliminary isolation layer 1047 may be left on a top of each device stack, but this may not affect a subsequent process), so as to form an electrical isolation layer 1047'.

Next, a conductive structure may be manufactured on the electrical isolation layer 1047'.

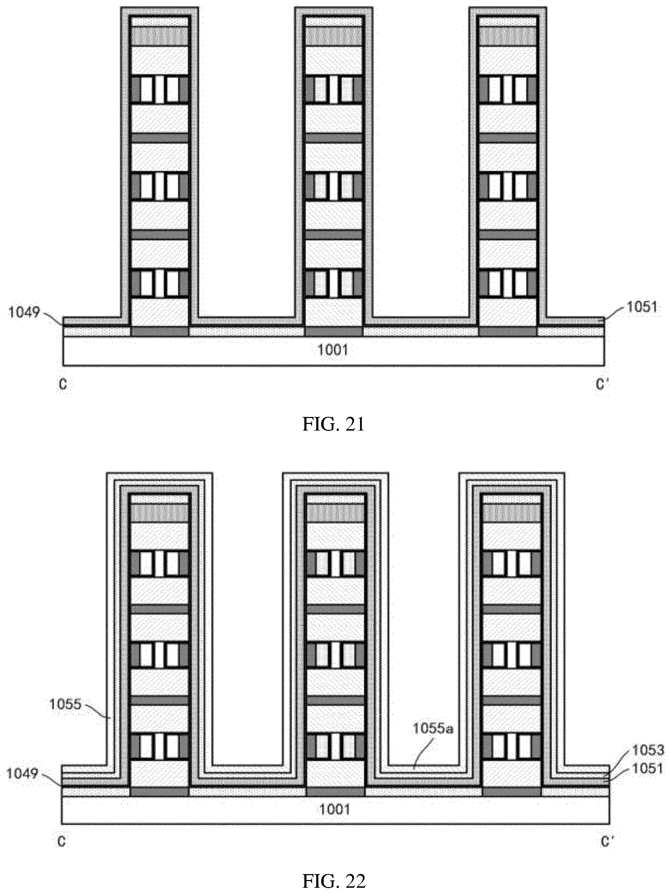

For example, as shown in FIG. 21, a conductive barrier layer 1049 and a conductive body layer 1051 may be sequentially formed in a substantially conformal manner by deposition. The conductive barrier layer 1049 may prevent a diffusion of the conductive body layer 1051 to the surroundings, and may contain, for example, a conductive nitride such as TiN, TaN, etc. The conductive body layer 1051 may be used to achieve an electrical connection between devices, and may contain, for example, a metal such as tungsten (W), cobalt (Co), rubidium (Ru), copper (Cu), aluminum (Al), nickel (Ni), etc. The formed conductive barrier layer 1049 and conductive body layer 1051 may be in contact with and connected to the first source/drain layer of the lowermost device in each device stack.

Then, the conductive barrier layer 1049 and the conductive body layer 1051 may be patterned as a conductive structure for the first source/drain layer of the lowermost device in each device stack. In this example, a portion of the conductive barrier layer 1049 and a portion of the conductive body layer 1051, which are located at a bottom portion of the groove, are desired to be left, and thus a mask covering the portions may be formed.

For example, the mask in such form may be performed by the method described above in combination with FIG. 19 to FIG. 20(b).

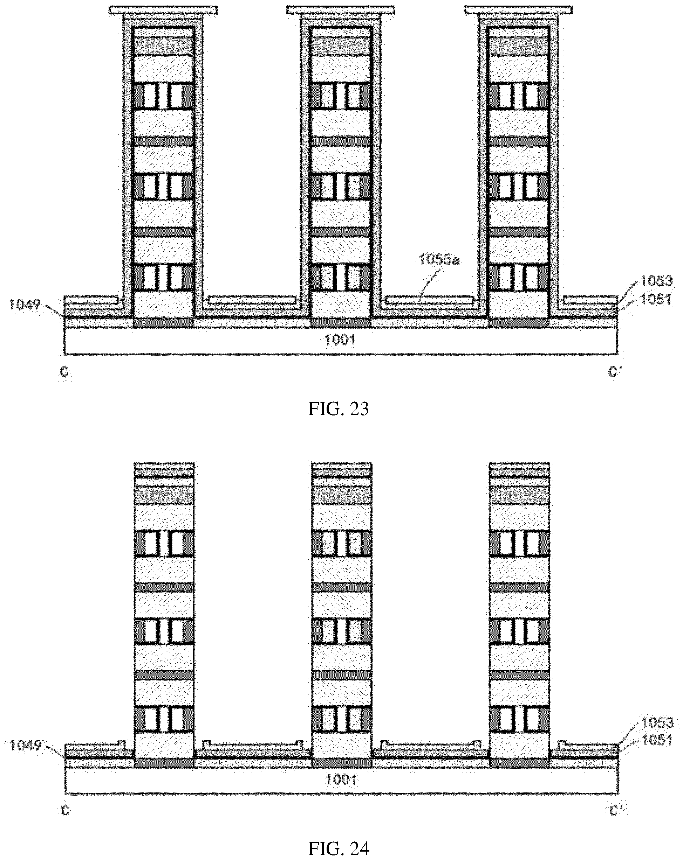

Alternatively, as shown in FIG. 22, a mask layer 1053 and a patterning auxiliary layer 1055 may be sequentially formed in a substantially conformal manner by deposition. For example, taking into account the etching selectivity, the mask layer 1053 may contain an oxide, and may have a thickness of about 1 nm to 5 nm. For convenience of a local modification (changing the etching selectivity), the patterning auxiliary layer 1055 may contain polysilicon or amorphous silicon, and may have a thickness of about 5 nm to 20 nm. An etching selectivity (with respect to a vertically extending portion of the patterning auxiliary layer 1055) of a horizontal extending portion 1055a of the patterning auxiliary layer 1055 may be changed by implanting an impurity such as B in the horizontal extending portion 1055a of the patterning auxiliary layer 1055 by ion implantation in the vertical direction and annealing at, for example, about 550 °C to about 900 °C. Then, as shown in FIG. 23, an undoped portion of the patterning auxiliary layer 1055 may be removed by a selective etching, such as a wet etching by using TMAH, so as to leave a doped portion 1055a thereof. The mask layer 1053 may be selectively etched by using the doped portion 1055a as an etching mask, so as to obtain a mask in a desired form. In order to control an amount of etching well, the ALE may be used. After that, the doped portion 1055a may be removed by the selective etching such as RIE.

As shown in FIG. 24, the conductive barrier layer 1049 and the conductive body layer 1051 may be isotropically etched by using the mask layer 1053 as an etching mask, so that the conductive barrier layer 1049 and the conductive body layer 1051 may be left at the bottom portion of the groove (a portion of the conductive barrier layer 1049 and the conductive body layer 1051 may be left at a top surface of the device stack, which may be removed in a subsequent process). Here, the ALE may be used to achieve a good etching control. After that, the mask layer 1053 may be removed by the selective etching such as RIE.

In this example, the doped portion 1055a is removed before the conductive pattern is patterned. However, the present disclosure is not limited to this. For example, the doped portion 1055a may be removed after the conductive pattern is patterned.

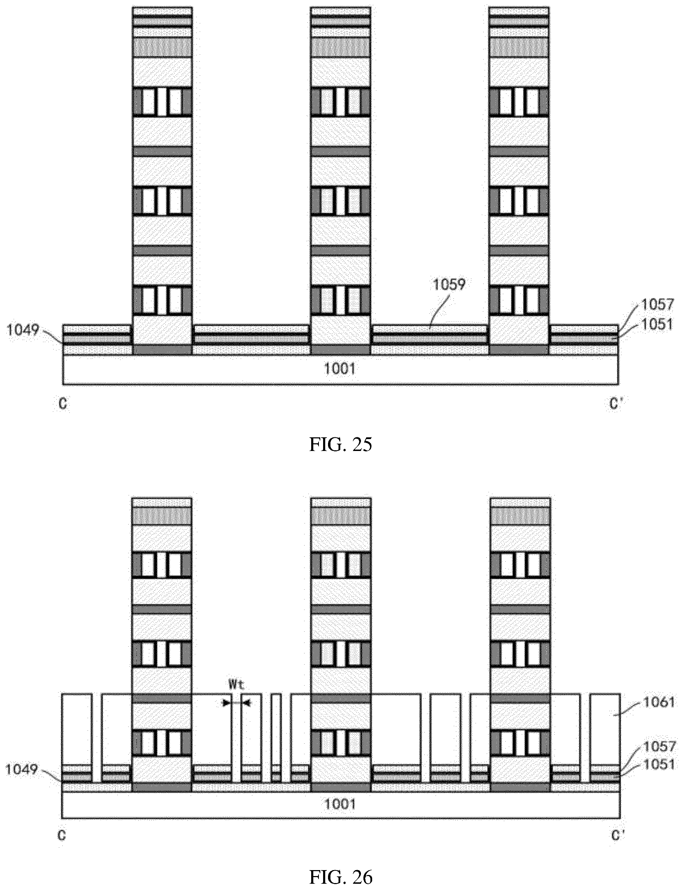

A top surface of the conductive body layer 1051 is currently exposed to the outside. In order to prevent a diffusion of the conductive body layer 1051, a barrier layer may be formed on the top surface of the conductive body layer 1051. For example, as shown in FIG. 25, a conductive barrier layer 1057 may be formed in a substantially conformal manner by deposition. The conductive barrier layer 1057 may contain the same or different material as or from a material of the conductive barrier layer 1049. Then, a mask layer 1059 such as an oxide may be formed by, for example, the method described above in combination with FIG. 22 to FIG. 24, and the conductive barrier layer 1057 may be isotropically etched by using the mask layer 1059, so that the conductive barrier layer 1057 may be left at the bottom portion of the groove (a portion of the conductive barrier layer 1057 may be left on the top surface of each device stack, which may be removed in the subsequent process).

Next, the conductive body layer 1051 wrapped by the conductive barrier layers 1049 and 1057 may be patterned. An alignment mark of the device layer L1 may assist in pattern positioning. For example, as shown in FIG. 26, a mask layer 1061 for patterning the conductive structure may be formed in the groove. For example, the mask layer 1061 may be formed by spin-coating and etching back a photoresist to thin the photoresist for convenience of exposure and leave the photoresist in the groove, and then patterning (e.g., photolithography or e-beam exposure, etc.) the photoresist with the assistance of the alignment mark of the device layer L1. A minimum gap Wt of each opening in the mask layer 1061 may be substantially uniform, which may help consistency of a subsequent process. In order to ensure such consistency, a portion of the conductive structure defined by the patterned photoresist may be a dummy conductive structure.

The selective etching such as RIE may be performed on the mask layer 1059, the conductive barrier layer 1057, the conductive body layer 1051 and the conductive barrier layer 1049 sequentially by using the mask layer 1061 as an etching mask. The RIE may be performed in a substantially vertical direction and may stop on an electrical isolation layer 1047" (or may slightly enter the electrical isolation layer 1047', so as to ensure that each conductive layer is cut off). In this way, a laterally extending conductive structure may be formed at a height corresponding to the first source/drain layer of the device layer L1 at the bottom portion of the groove, and at least one of the conductive structures is in contact with and therefore electrically connected to the lowermost first source/drain layer in each device stack. In addition, due to the etching step, a residue on the top surface of each device stack in the previous process may be removed. After that, the mask layer 1061 may be removed.

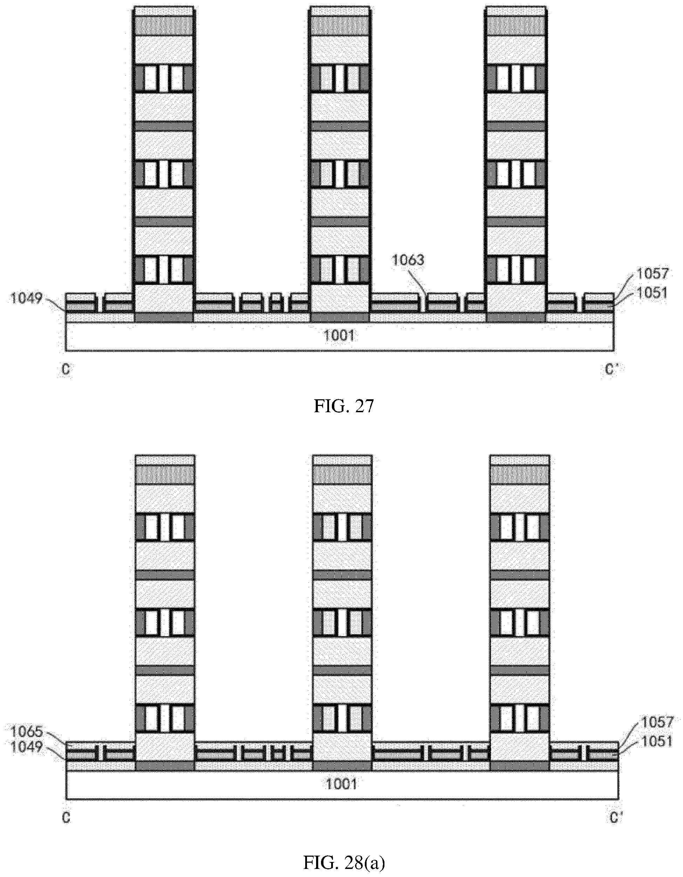

Due to such etching, a portion of a sidewall of the conductive body layer 1051 is exposed to the outside. In order to prevent a diffusion of the conductive body layer 1051, a conductive barrier layer may be formed on the sidewall of the conductive body layer 1051. For example, as shown in FIG. 27, a conductive barrier layer 1063 may be formed sequentially in a substantially conformal manner by deposition, and a laterally extending portion of the conductive barrier layer 1063 may be removed while a vertically extending portion of the conductive barrier layer 1063 may be left by an anisotropic etching such as RIE in the vertical direction, so that the conductive barrier layer 1063 may be formed in a spacer form and left on the sidewall of the conductive body layer 1051. The conductive barrier layer 1063 may contain the same or different material as or from the material of the conductive barrier layers 1049 and 1057. In order to maintain consistency, the conductive barrier layers 1049, 1057 and 1063 may have a same material and substantially a same film thickness.

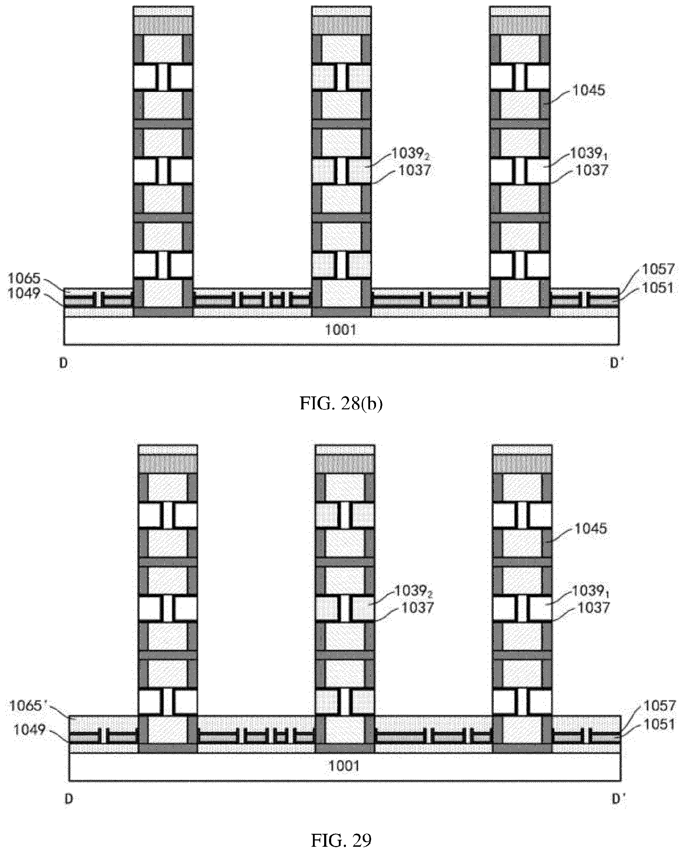

The conductive barrier layer 1063 in the spacer form only needs to cover the conductive body layer 1051. To this end, as shown in FIG. 28(a) and FIG. 28(b), the groove, particularly a gap between the conductive structures, may be filled with a dielectric layer 1065 (e.g., an oxide). The dielectric layer 1065 may be formed by deposition and then etching back. The deposited dielectric layer 1065 may have a thickness greater than Wt/2, so that the gap between the conductive structures may be fully filled.

Since the dielectric layer 1065 is located inside the groove, it is difficult to perform a planarization process such as CMP on the dielectric layer 1065. In order to ensure a flatness of a top surface of the dielectric layer 1065 so as to facilitate a subsequent photolithography, the conductive structure may include some dummy patterns (that is, an interconnection line and/or a via hole that does not achieve a real electrical connection) so that a minimum gap may be substantially maintained uniform as described above. In addition, a deposited film thickness may be greater than half of the minimum gap. In order to better control the flatness of the dielectric layer 1065, the dielectric layer 1065 may be deposited by Atomic Layer Deposition (ALD) and etched back by the ALE.

Next, a portion of the conductive barrier layer 1063 exposed by the dielectric layer 1065 may be removed by the selective etching, such as RIE. In this way, the conductive body layer 1051 may be encapsulated by the conductive barrier layers 1049, 1057 and 1063. The conductive structure thus formed and the device stack (e.g., the components requiring a connection, such as the source/drain region, the gate electrode, etc.) may have an interface or a boundary therebetween due to factors such as a material difference, a misalignment of up and down or front to back position, etc. In addition, the dielectric layer 1065 and the device stack (e.g., an interlayer dielectric layer therein) may also have an interface or a boundary therebetween. The dielectric layer 1065 may also form a portion of the electrical isolation layer and is referred to hereinafter as an electrical isolation layer.

A layer of conductive structure is formed as above. Multilayer conductive structures may be formed one by one in the same or similar manner.

Next, for example, a conductive structure for a gate conductor layer of the lowermost device in each device stack may be formed. The conductive structure to be formed for the gate conductor layer may be located at a height corresponding to the gate conductor layer. To this end, as shown in FIG. 29, a dielectric material such as an oxide may be deposited and then etched back by, for example, the method described above in combination with FIG. 19 to FIG. 20(b), so as to raise a top surface of the electrical isolation layer 1065 to the height corresponding to the gate conductor layer. The raised electrical isolation layer is denoted by 1065' in FIG. 29. It should be noted that although the electrical isolation layer 1065' is shown here as a whole, successively formed layers may have an interface or a boundary therebetween. Here, the residue on the top surface of each device stack may be thickened (the thickening is not shown in FIG. 29 for convenience only).

Here, a height of a top surface of the electrical isolation layer 1065' may cause that, on one hand, the exposed sidewall of the first source/drain layer in the groove may be shielded, so as to prevent the conductive structure subsequently formed on the top surface of the electrical isolation layer 1065' from contacting the first source/drain layer; and on the other hand, the sidewall of the gate conductor layer may be exposed in the groove, so that the conductive structure subsequently formed on the top surface of the electrical isolation layer 1065' may be in contact with the gate conductor layer.

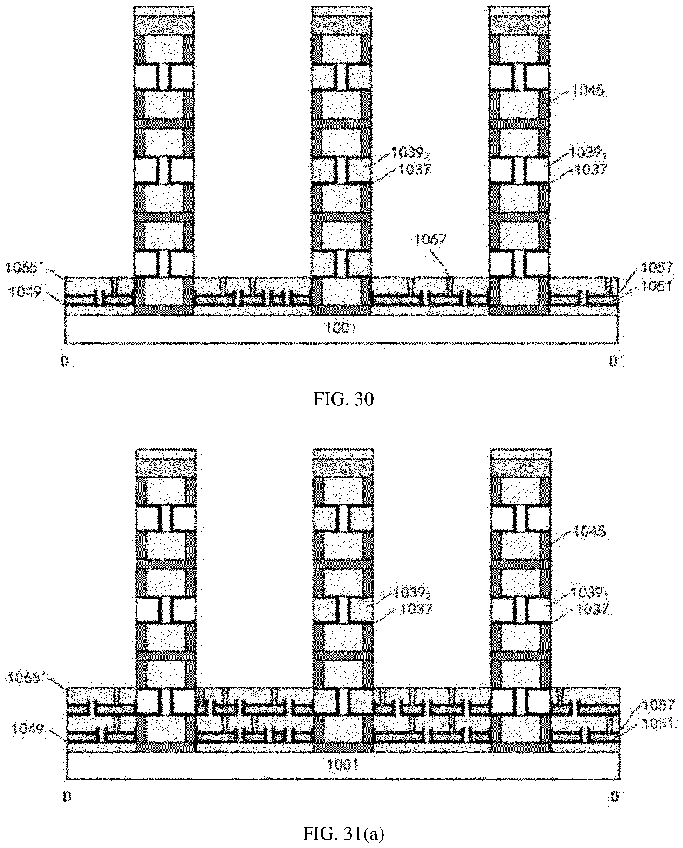

As shown in FIG. 30, a via hole 1067 may be formed in the electrical isolation layer 1065' by, for example, etching the electrical isolation layer 1065' to obtain a hole and filling the hole with a conductive barrier layer such as a conductive nitride and a conductive material such as a metal. The via hole 1067 may achieve an electrical connection between upper and lower layers. One or more of the via holes adjacent to a sidewall of the device stack may be in direct contact with the first source/drain layer.

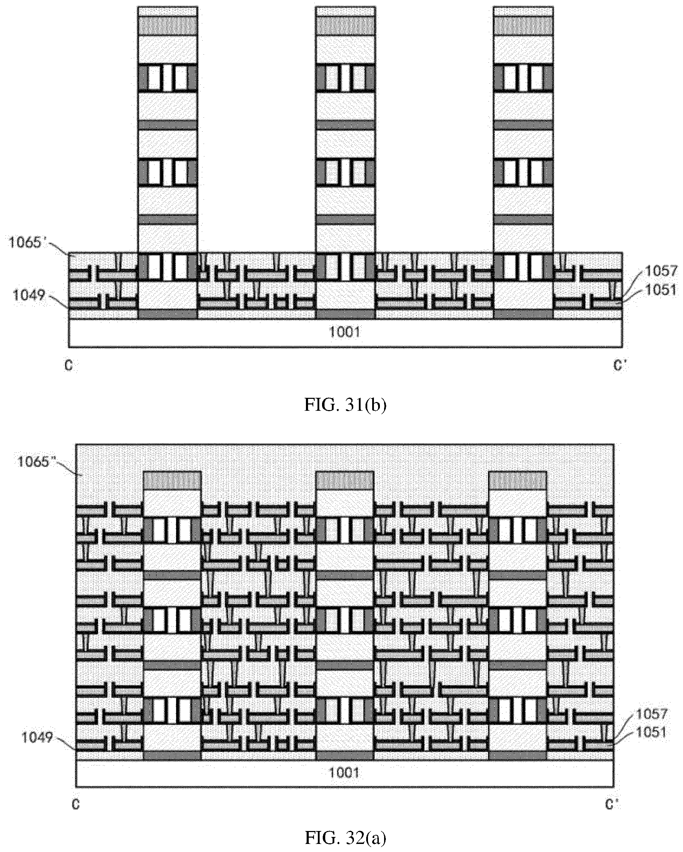

In addition, as shown in FIG. 31(a) and FIG. 31(b), the conductive structure may be formed on the electrical isolation layer 1065' as described above in combination with FIG. 21 to FIG. 28(b). Then, a height of the electrical isolation layer 1065' may be further raised. Here, the height of the top surface of the electrical isolation layer 1065' may cause that, on one hand, the sidewall of the gate conductor layer exposed in the groove may be shielded, so as to prevent the conductive structure subsequently formed on the top surface of the electrical isolation layer 1065' from contacting the gate conductor layer; and on the other hand, the sidewall of the second source/drain layer may be exposed in the groove, so that the conductive structure subsequently formed on the top surface of the electrical isolation layer 1065' may be in contact with the second source/drain layer. Similarly, the via hole may be formed in the electrical isolation layer 1065'.

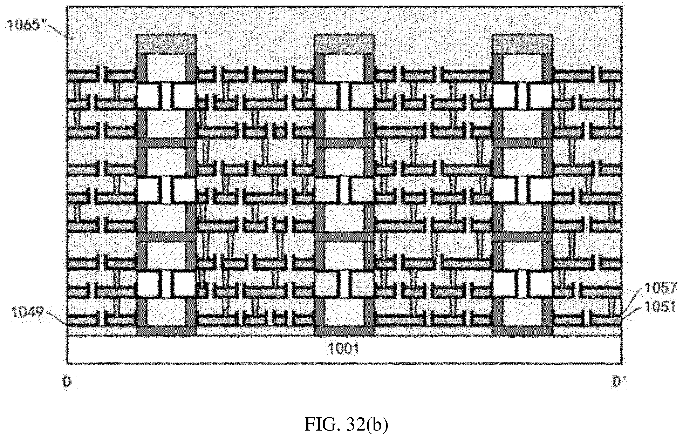

In this way, as shown in FIG. 32(a) and FIG. 32(b), the conductive structures may be formed layer by layer, so as to form the interconnection structure. Here, for the first source/drain layer, the gate conductor layer and the second source/drain layer in each device layer, a corresponding conductive structure may be formed at a corresponding height to achieve a desired interconnection. In FIG. 32(a) and FIG. 32(b), an electrical isolation layer between the conductive structures in the interconnection structure is shown as 1065". At least some of the above-mentioned interfaces or boundaries in the layers may be substantially coplanar with each other, e.g., substantially aligned with each other in the vertical direction.

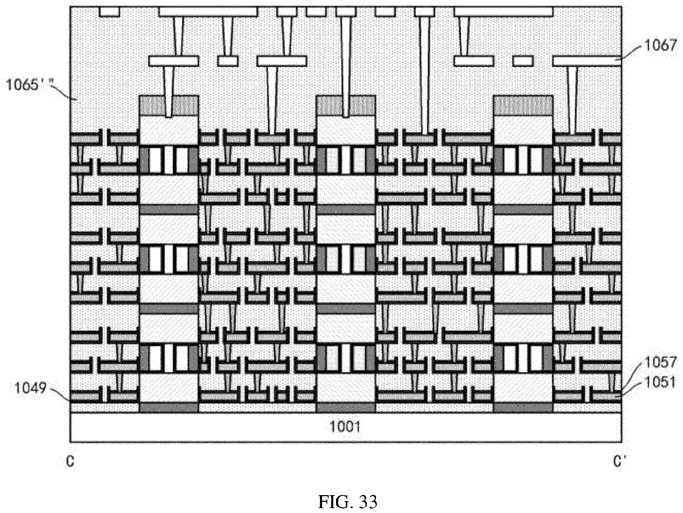

After that, a leading-out terminal of the interconnection structure may be manufactured. For example, as shown in FIG. 33, an interlayer dielectric layer (shown here as 1065'" integrally with the electrical isolation layer) may be formed by, for example, depositing and planarizing a dielectric material such as an oxide, and an interconnection structure 1067 such as an interconnection line or a via hole may be formed in the interlayer dielectric layer 1065'". The interconnection structure 1067 may be in contact with and electrically connected to the interconnection structure previously formed in the groove.

In the above-mentioned embodiments, the isolation layer is provided between adjacent device layers. However, the present disclosure is not limited to this. For example, some device layers may be directly adjacent to each other, particularly in a case of a Complementary Metal Oxide Semiconductor (CMOS) process.

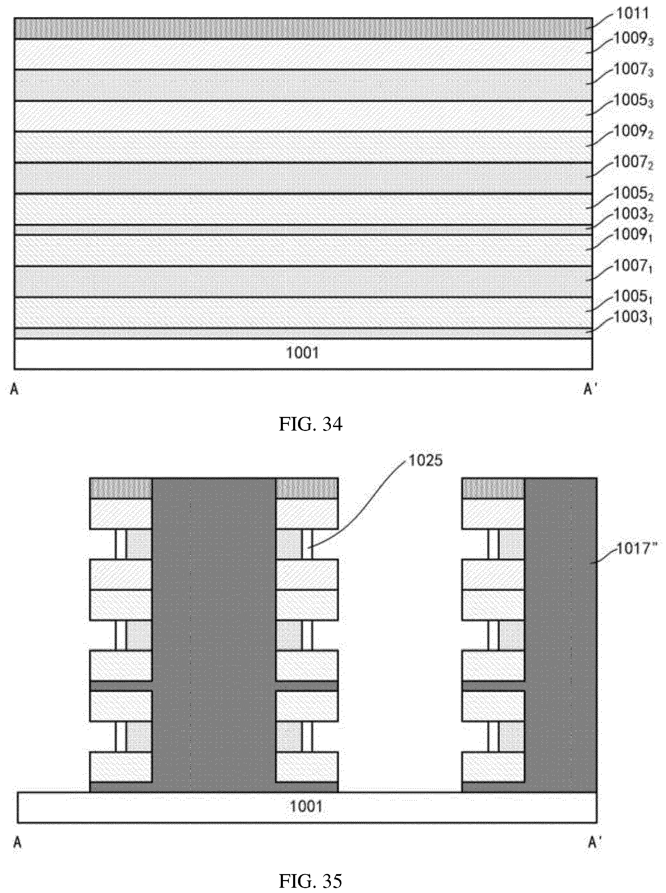

FIG. 34 to FIG. 36 schematically show some stages in a process of manufacturing a semiconductor apparatus, in particular an interconnection structure therein, according to another embodiment of the present disclosure.

As shown in FIG. 34, each material layer may be provided on the substrate 1001 as described above in combination with FIG. 1. The difference from the above-mentioned embodiments is that each source/drain layer may be doped in situ during growth, so that diffusion doping by using a dopant source layer is not needed. In this example, the source/drain layers in the device layers L1 and L2 may be doped as p-type, while the source/drain layer in the device layer L3 may be doped as n-type. Another difference is that no sacrificial layer 1003₃ is provided between the device layers L2 and L3, so that the device layers L2 and L3 may be directly adjacent to each other.

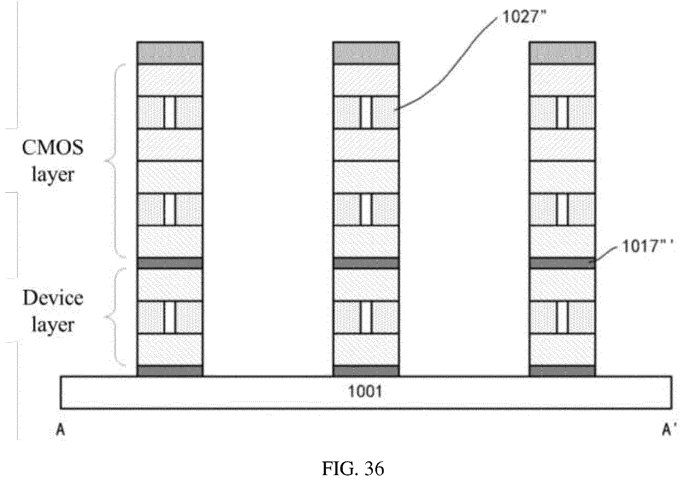

Next, the isolation layer may be formed and the channel layer 1025 may be formed by the same process as described above, as shown in FIG. 35. FIG. 36 shows a case after the position retaining layer 1027" is formed around the channel layer 1025. As shown in FIG. 36, the device layers L2 and L3 has no isolation layer 1017''' therebetween and are directly adjacent to each other, that is, subsequently formed p-type and n-type devices are in direct contact with each other and therefore electrically connected to each other, so that a CMOS structure may be formed.

After that, the manufacturing of the device may be completed by the above-mentioned method.

The semiconductor apparatus according to embodiments of the present disclosure may be applied to various electronic devices. Accordingly, the present disclosure further provides an electronic device including the above-mentioned semiconductor apparatus. The electronic device may further include a display screen, a wireless transceiver and other components. The electronic device may include, for example, a smart phone, a personal computer (PC), a tablet computer, an artificial intelligence device, a wearable device, a mobile power supply, etc.

According to embodiments of the present disclosure, a method of manufacturing a system on chip (SoC) is further provided, which may include the above-mentioned method. Specifically, a variety of devices may be integrated on the chip, at least some of which are manufactured according to the method of the present disclosure.

In the above description, the technical details such as patterning and etching of each layer have not been described in detail. However, those skilled in the art should understand that various technical means may be used to form layers, regions, etc. of desired shapes. In addition, in order to form the same structure, those skilled in the art may further design a method that is not completely the same as the above-mentioned method. In addition, although various embodiments are described above separately, this does not mean that the measures in the various embodiments may not be advantageously used in combination.

Embodiments of the present disclosure have been described above. However, these embodiments are for illustrative purposes only, and are not intended to limit the scope of the present disclosure. The scope of the present disclosure is defined by the appended claims and their equivalents. Without departing from the scope of the present disclosure, those skilled in the art may make various substitutions and modifications, and these substitutions and modifications should all fall within the scope of the present disclosure.

## Claims

1. A semiconductor apparatus, comprising:
a plurality of device stacks, wherein each device stack comprises a plurality of semiconductor devices that are stacked, and each semiconductor device comprises a first source/drain layer, a channel layer, and a second source/drain layer that are stacked in a vertical direction, and a gate electrode surrounding the channel layer; and
an interconnection structure disposed between the plurality of device stacks,
wherein the interconnection structure comprises:
an electrical isolation layer; and
a conductive structure in the electrical isolation layer, and
wherein at least one of the first source/drain layer, the second source/drain layer, and the gate electrode of each of at least one of the semiconductor devices is in contact with and thus electrically connected to the conductive structure at a corresponding height in the interconnection structure in a lateral direction.

2. The semiconductor apparatus according to claim 1, further comprising a device isolation layer between at least one pair of semiconductor devices adjacent in the vertical direction.

3. The semiconductor apparatus according to claim 1 or 2, wherein the channel layer comprises a single crystal semiconductor material.

4. The semiconductor apparatus according to claim 1 or 2, wherein each of the first source/drain layer and the second source/drain layer comprises a single crystal semiconductor material.

5. The semiconductor apparatus according to claim 2, wherein a thickness of the device isolation layer is substantially uniform in the device stack, and the thickness of the device isolation layer is less than a thickness of the channel layer.

6. The semiconductor apparatus according to claim 2, wherein the device isolation layers at a corresponding height in different device stacks are substantially coplanar with each other.

7. The semiconductor apparatus according to claim 2, wherein the device isolation layer comprises an oxide, a nitride, SiC, or a combination thereof.

8. The semiconductor apparatus according to claim 2, wherein an interface is provided between the device isolation layer and the electrical isolation layer.

9. The semiconductor apparatus according to claim 1 or 2, wherein the channel layers of the semiconductor devices in a same device stack are substantially coplanar with each other.

10. The semiconductor apparatus according to claim 1 or 2, wherein the first source/drain layer and the second source/drain layer of each semiconductor device in at least one or more of the device stacks are substantially rectangular or zigzag in a top view.

11. The semiconductor apparatus according to claim 1 or 2, wherein a sidewall of the gate electrode of each semiconductor device in at least one of the device stacks, which is on a first side, is covered by a first sidewall isolation layer, while sidewalls of the first source/drain layer and the second source/drain layer, which are on a second side different from the first side, are covered by a second sidewall isolation layer.

12. The semiconductor apparatus according to claim 11, wherein the first sidewall isolation layers in a same device stack are substantially coplanar with each other, and the second sidewall isolation layers in the same device stack are substantially coplanar with each other.

13. The semiconductor apparatus according to claim 11, wherein an interface is provided between the first sidewall isolation layer and the electrical isolation layer, and an interface is provided between the second sidewall isolation layer and the electrical isolation layer.

14. The semiconductor apparatus according to claim 11, wherein the gate electrode is connected, on the second side, to a corresponding conductive structure in the interconnection structure, and the first source/drain layer and the second source/drain layer are connected, on the first side, to corresponding conductive structures in the interconnection structure.

15. The semiconductor apparatus according to claim 1 or 2, wherein the conductive structure comprises at least one of an interconnection line and a via hole.

16. The semiconductor apparatus according to claim 15, wherein the conductive structure comprises an interconnection line layer and a via hole layer that are disposed alternately, wherein the interconnection line is provided in the interconnection line layer, and the via hole is provided in the via hole layer.

17. The semiconductor apparatus according to claim 1 or 2, wherein the conductive structure comprises at least one of metal elements W, Co, Ru, Cu, Al, Ti, Ni and Ta.

18. The semiconductor apparatus according to claim 1 or 2, wherein the interconnection structure surrounds at least one of the semiconductor devices.

19. The semiconductor apparatus according to claim 1, wherein an interface is provided between the conductive structure in the interconnection structure and the device stack.

20. The semiconductor apparatus according to claim 1, wherein an interface is provided between the electrical isolation layer in the interconnection structure and the device stack.

21. The semiconductor apparatus according to claim 8, 13, 19 or 20, wherein at least two of the interfaces at different heights are substantially coplanar with each other.

22. The semiconductor apparatus according to claim 1 or 2, wherein the interconnection structure comprises a dummy conductive structure, and a minimum gap between conductive structures in a same layer, a minimum gap between the conductive structure and the dummy conductive structure in the same layer, and a minimum gap between dummy conductive structures in the same layer remain substantially consistent with each other in the layer.

23. The semiconductor apparatus according to claim 1, wherein at least one pair of semiconductor devices adjacent in the vertical direction have different conductive types, so that a complementary metal oxide semiconductor CMOS configuration is formed.

24. A method of manufacturing a semiconductor apparatus, comprising:
providing a stack on a substrate, wherein the stack comprises one or more device layers, and each device layer comprises a first source/drain layer, a channel defining layer, and a second source/drain layer that are sequentially stacked;
patterning the stack as a column for defining an active region;
forming a channel layer based on the channel defining layer, wherein the channel layer is relatively recessed in a lateral direction with respect to the first source/drain layer and the second source/drain layer;
forming a gate electrode in a recess of the channel layer with respect to the first source/drain layer and the second source/drain layer;
forming an interconnection structure around the column, wherein the interconnection structure comprises an electrical isolation layer and a conductive structure in the electrical isolation layer,
wherein the method further comprises controlling a height of the conductive structure in the interconnection structure, so that at least one of the first source/drain layer, the second source/drain layer, and the gate electrode of each of at least one of semiconductor devices is in contact with and thus electrically connected to the conductive structure at a corresponding height in the lateral direction.

25. The method according to claim 24, wherein the stack further comprises a sacrificial layer between the device layer and the substrate and/or between at least one pair of adjacent device layers, and
the method further comprises: maintaining a side of the column after forming the column, so as to replace the sacrificial layer with a device isolation layer.

26. The method according to claim 24 or 25, wherein the stack is provided by epitaxial growth.

27. The method according to claim 24 or 25, wherein two layers adjacent in the stack have an etching selectivity with respect to each other.

28. The method according to claim 25, wherein the replacing the sacrificial layer with a device isolation layer comprises:
relatively recessing, by selective etching, the channel defining layer and the sacrificial layer in the lateral direction;
forming a filling layer in a lateral recess of the sacrificial layer, and forming a position retaining layer in a lateral recess of the channel defining layer;
removing, by selective etching, the filling layer and the sacrificial layer exposed by a removal of the filling layer; and
forming the device isolation layer in a gap obtained by the removal of the filling layer and a removal of the sacrificial layer.

29. The method according to claim 28, wherein the forming a filling layer comprises:
forming the filling layer by epitaxial growth, wherein a growth thickness of the filling layer is greater than half a thickness of the sacrificial layer, but less than half a thickness of the channel defining layer and less than a lateral recessed depth of the channel defining layer; and
selectively etching the filling layer of a certain thickness.

30. The method according to claim 28, wherein the forming the channel layer comprises:
removing the position retaining layer and epitaxially growing the channel layer on a sidewall of the channel defining layer.

31. The method according to claim 30, further comprising: before epitaxially growing the channel layer,
etching back the first source/drain layer, the second source/drain layer and the channel defining layer of a certain thickness, wherein the thickness is substantially equal to a growth thickness of the channel layer.

32. The method according to claim 30, further comprising: removing the channel defining layer from the side of the column by selective etching.

33. The method according to claim 24, further comprising:
shielding a first side of the column, and relatively recessing the gate electrode in the lateral direction by selective etching, so as to form a first sidewall isolation gap;
shielding a second side of the column that is different from the first side of the column, and relatively recessing the first source/drain layer and the second source/drain layer in the lateral direction by selective etching, so as to form a second sidewall isolation gap; and
filling the first sidewall isolation gap and the second sidewall isolation gap with a sidewall isolation layer.

34. The method according to claim 24, wherein the forming the interconnection structure comprises:
alternately forming an interconnection line layer and a via hole layer, wherein an interconnection line is provided in the interconnection line layer, and a via hole is provided in the via hole layer.

35. The method according to claim 34, wherein the forming an interconnection line layer and a via hole layer comprises:
forming an interconnection line at a first height around the column, wherein the first height causes the interconnection line to be at substantially a same height as the gate electrode, the first source/drain layer, or the second source/drain layer of a corresponding semiconductor device;
filling a dielectric material around the column to bury the interconnection line, wherein a top surface of the dielectric material is at a second height, and the second height causes an interconnection line subsequently formed on the dielectric material to be at substantially a same height as the gate electrode, the first source/drain layer, or the second source/drain layer of the corresponding semiconductor device; and
forming a via hole in the dielectric material.

36. The method according to claim 35, wherein the forming an interconnection line comprises:
forming a conductive material layer; and
patterning the conductive material layer as a plurality of line patterns extending in a plane, wherein at least one of the plurality of line patterns forms the interconnection line,
wherein minimum gaps between the line patterns remain substantially consistent with each other.

37. The method according to claim 36, further comprising:
forming a conductive barrier layer surrounding the line pattern.

38. An electronic device comprising the semiconductor apparatus according to any one of claims 1 to 23.

39. The electronic device according to claim 38, wherein the electronic device comprises a smart phone, a personal computer, a tablet computer, an artificial intelligence device, a wearable device or a mobile power supply.
